# EUROPEAN PATENT APPLICATION

(11) **EP 4 808 300 A1**
(43) Date of publication of application: **16.09.2026**
(21) Application number: 25797457.6
(22) Date of filing: 28.04.2025
(51) Int. Cl.: H05K 7/20

(54) **ELECTRONIC DEVICE**

(30) Priority: 30.04.2024 CN 202410557549; 30.10.2024 CN 202422652226 U; 12.12.2024 CN 202411834192; 09.04.2025 CN 202510443584
(71) Applicant: Huawei Technologies Co., Ltd., Shenzhen, Guangdong 518129 (CN)
(72) Inventor: ZHEN, Haitao, Shenzhen, Guangdong 518129 (CN); ZHAO, Yangyang, Shenzhen, Guangdong 518129 (CN); LIU, Yahao, Shenzhen, Guangdong 518129 (CN); LAI, Ben, Shenzhen, Guangdong 518129 (CN); HU, Jian, Shenzhen, Guangdong 518129 (CN); ZHU, Mingchao, Shenzhen, Guangdong 518129 (CN); REN, Xixi, Shenzhen, Guangdong 518129 (CN); LUO, Yang, Shenzhen, Guangdong 518129 (CN)
(74) Representative: Huawei European IPR
(86) International application number: PCT/CN2025/091821
(87) International publication number: WO 2025/228336

(57) **Abstract**

Embodiments of this application provide an electronic device. A first component module and a first heat dissipation assembly in the electronic device are disposed in a space in which a first middle frame is located. The first heat dissipation assembly is configured to perform active heat dissipation for a first heat source in the first component module. A part of the first heat dissipation assembly is built into the first middle frame. A second component module, a second heat dissipation assembly, and a battery are disposed in a space in which a second middle frame is located. The second component module passes through a folding rotating shaft through an FPC and is connected to a mainboard. The second heat dissipation module is configured to perform passive heat dissipation for a second heat source in the second component module. Power of the first heat source is greater than power of the second heat source. A maximum size of the first heat source in a thickness direction of the electronic device is less than a maximum size of the second heat source in the thickness direction of the electronic device. In this application, components with different load levels and different heights in the electronic device are respectively arranged on two opposite sides of the rotating shaft based on respective heat dissipation requirements, to implement aesthetically pleasing thinning and improve use comfort.

## Description

This application claims priority to Chinese Patent Application No. 202410557549.4, filed with the China National Intellectual Property Administration on April 30, 2024 and entitled "ELECTRONIC DEVICE", which is incorporated herein by reference in its entirety. This application claims priority to Chinese Patent Application No. 202422652226.1, filed with the China National Intellectual Property Administration on October 30, 2024 and entitled "FOLDABLE DISPLAY DEVICE", which is incorporated herein by reference in its entirety. This application further claims priority to Chinese Patent Application No. 202411834192.6, filed with the China National Intellectual Property Administration on December 12, 2024 and entitled "ELECTRONIC DEVICE", which is incorporated herein by reference in its entirety. This application further claims priority to Chinese Patent Application No. 202510443584.8, filed with the China National Intellectual Property Administration on April 9, 2025 and entitled "ELECTRONIC DEVICE", which is incorporated herein by reference in its entirety.

### TECHNICAL FIELD

This application relates to the field of electronic technologies, and in particular, to an electronic device.

### BACKGROUND

For portable electronic devices such as a mobile phone, a tablet, and a computer, lightness and thinness are a development trend. A foldable electronic device has a foldable screen, and the foldable screen can provide large-screen display effect in a flattened state. In addition, the foldable electronic device is portable in a folded state, and therefore is highly favored by users. The foldable electronic device includes a first main body and a second main body that can be folded relative to each other. A mainboard is disposed in the first main body, and many core functional components and a heat dissipation architecture need to be stacked in the first main body. Therefore, the first main body needs a thick space. In the second main body, a battery is mainly disposed, and no component of a large size needs to be carried. Because the second main body is thin in size, such a design results in an increase in a thickness difference between the first main body and the second main body. When the foldable-screen electronic device can present a large-screen use form in the flattened state, because the thickness difference between the first main body and the second main body is large, comfort of the large-screen use form is affected, and use experience is affected. Therefore, an urgent problem that needs to be resolved currently is to design an aesthetically pleasing, light, and thin electronic device with a foldable screen, so that spaces of two main bodies can be fully used when the foldable screen is in the flattened state, to reduce a thickness difference between the two main bodies.

### SUMMARY

Embodiments of this application provide an electronic device. Components with different load levels and different heights are respectively arranged on two opposite sides of a rotating shaft based on respective heat dissipation requirements, to effectively reduce a thickness difference between two main bodies of the electronic device that can be folded and unfolded relative to each other. On one side, a fan is used for active heat dissipation, and the fan is built into a middle frame to reduce an overall thickness. On the other side, a component passes through the folding rotating shaft through a segmented FPC and is connected to a mainboard, and passive heat dissipation is implemented through an overall feature structure. An overall ultra-thin design is implemented through systematic overall stacking.

According to a first aspect, an embodiment of this application provides an electronic device. The electronic device includes a first middle frame, a second middle frame, a rotating shaft, a screen, a first component module, a first heat dissipation assembly, a second component module, a second heat dissipation assembly, and a battery. The rotating shaft is connected between the first middle frame and the second middle frame. The screen covers the first middle frame, the rotating shaft, and the second middle frame. The first component module and the first heat dissipation assembly are disposed in an internal space, of the electronic device, in which the first middle frame is located. The first heat dissipation assembly is configured to perform active heat dissipation for a first heat source in the first component module. The second component module, the second heat dissipation assembly, and the battery are disposed in an internal space, of the electronic device, in which the second middle frame is located. The second component module is located between the battery and the rotating shaft. The second heat dissipation module is configured to perform passive heat dissipation for a second heat source in the second component module. Power of the first heat source is greater than power of the second heat source. A maximum size of the first heat source in a thickness direction of the electronic device is less than a maximum size of the second heat source in the thickness direction of the electronic device.

Active heat dissipation may be understood as follows: A fan or another device (for example, a pump) is used for direct forced convection, to accelerate transfer of heat from a heat source (for example, a chip) to an external environment. Passive heat dissipation may be understood as follows: Heat is dissipated from a surface of a device to an environment through natural convection or radiation based on thermal conductivity of a material.

In this embodiment of this application, the first component module and the second component module are respectively disposed on the first middle frame and the second middle frame on two opposite sides of the rotating shaft, active heat dissipation is performed for the first component module with high heat generation power and a small thickness, and passive heat dissipation is performed for the second component module with low heat generation power and a large thickness. Compared with stacking both the first component module and the second component module on the first middle frame and performing active heat dissipation, in this implementation of this application, disposing the second component module with a large thickness on the second middle frame can reduce an overall thickness of the first middle frame, so that a thickness difference between a main body, of the electronic device, in which the first middle frame is located and a main body, of the electronic device, in which the second middle frame is located is reduced. In this application, the first component module and the second component module are respectively disposed on the first middle frame and the second middle frame on the two opposite sides of the rotating shaft, so that the first heat source and the second heat source are distributed in different main bodies of the electronic device, and environments in which the first heat source and the second heat source are located have an appropriate working temperature. This helps ensure working performance of the first heat source and the second heat source, and helps improve temperature equalization performance and heat dissipation efficiency of the electronic device. In addition, the second component module is disposed at a position between the battery and the rotating shaft, and the second component module and the rotating shaft are disposed side by side without overlapping. This helps control a thickness of the main body, of the electronic device, in which the second middle frame is located. In addition, the second component module is adjacent to the rotating shaft, and the rotating shaft may serve as a medium for passive heat dissipation of the second component module. This helps improve heat dissipation efficiency.

In an implementation of the first aspect, the second heat dissipation assembly conducts heat from the second component module to the rotating shaft. The second heat dissipation assembly conducts the heat from the second component module to the rotating shaft, so that the rotating shaft is connected to the second heat dissipation assembly, and the rotating shaft can participate in heat dissipation of the second component module. The rotating shaft may be considered as a part of the second heat dissipation assembly. This implementation expands an area of the second heat dissipation assembly, and helps improve heat dissipation efficiency.

In a possible implementation, a value range of a shortest distance between a heat generation center position of the second heat source and an edge of the rotating shaft is less than or equal to 5 cm. The heat generation center position of the second heat source may be obtained through measurement. In this solution, the value range of the shortest distance between the edge of the rotating shaft and the center position of the second heat source in a specific implementation solution is constrained. The constraint indicating that the distance is less than or equal to 5 cm helps obtain good heat dissipation effect, and helps implement structural compactness of components arranged in the second middle frame, to properly arrange a space in the electronic device.

In a possible implementation, the edge of the rotating shaft is an edge that is adjacent to the second heat source and that is of a door panel that is of the rotating shaft and that corresponds to the second middle frame. The door panel of the rotating shaft is a door panel that is of the rotating shaft and that is adjacent to a screen side. For example, in an electronic device, the rotating shaft has two door panel structures: a left door panel and a right door panel, and one door panel (for example, the right door panel) is located on one side of the second middle frame. In this case, a value range of a shortest distance between an edge of the right door panel and the heat generation center position of the second heat source is less than or equal to 5 cm. The rotating shaft may alternatively have three door panels or another quantity of door panels.

In an implementation of the first aspect, the second heat dissipation assembly includes a heat dissipation plate and a thermally conductive structure, and the second component module includes a second circuit board and the second heat source. The second heat source is disposed on the second circuit board, the heat dissipation plate is located on a side that is of the second heat source and that faces away from the second circuit board, a part of the thermally conductive structure is located between the heat dissipation plate and a rear cover of the electronic device, and a part of the thermally conductive structure and the rotating shaft are disposed in a stacked manner, to transfer heat from the second heat source to the rotating shaft through the thermally conductive structure. In this embodiment, a heat transfer path of the second heat source is as follows: Heat generated by the second heat source sequentially passes through the heat dissipation plate, the thermally conductive structure, a part of the second middle frame, and the rotating shaft, and the heat may be dissipated through the rotating shaft. A part of the thermally conductive structure and the rotating shaft are disposed in a stacked manner, so that a heat conduction path can be constructed between the rotating shaft and the heat dissipation plate in a limited space. This helps properly control a size in the thickness direction of the electronic device, and improve heat dissipation efficiency of the electronic device. For example, the thermally conductive structure may be a graphite sheet.

In an implementation, the heat dissipation plate may be a metal plate or a heat sink structure with a heat dissipation fin. Alternatively, the heat dissipation plate may be a heat dissipation structure of another type such as a vapor chamber or a combination of a metal plate and a heat pipe.

In an implementation of the first aspect, the second circuit board and the second middle frame are connected through a thermally conductive medium, the screen of the electronic device is on a side that is of the second middle frame and that faces away from the second circuit board, and the thermally conductive structure is located between the heat dissipation plate and the rear cover of the electronic device. That is, in the thickness direction of the electronic device, the screen, the second middle frame, the thermally conductive medium, the second circuit board, the second heat source, the heat dissipation plate, the thermally conductive structure, and the rear cover can be sequentially disposed in a stacked manner, so that a first heat transfer path of the second heat source, the heat dissipation plate, the thermally conductive structure, and the rotating shaft and a second heat transfer path of the second heat source, the second circuit board, the thermally conductive medium, the second middle frame, and the rotating shaft can be established. In this solution, the rotating shaft may be considered as a part of the second heat dissipation assembly, and this solution helps properly control a size in the thickness direction of the electronic device, and improve heat dissipation efficiency of the electronic device.

In an implementation of the first aspect, the thermally conductive structure includes a first thermally conductive portion and a second thermally conductive portion. The first thermally conductive portion and the second thermally conductive portion are respectively located on two opposite sides of the second heat source in the thickness direction of the electronic device. The first thermally conductive portion is located between the heat dissipation plate and the rear cover of the electronic device, and the second thermally conductive portion is located between the second middle frame and the screen. The first thermally conductive portion extends to overlap the rotating shaft in the thickness direction of the electronic device, to form a first heat transfer path of the second heat source, the heat dissipation plate, the first thermally conductive portion, and the rotating shaft. Alternatively, the first thermally conductive portion extends to overlap the battery in the thickness direction of the electronic device, to form a second heat transfer path of the battery, the first thermally conductive portion, and the rear cover. Alternatively, the second thermally conductive portion extends to overlap the battery in the thickness direction of the electronic device, to form a third heat transfer path of the battery, the second middle frame, and the second thermally conductive portion. Alternatively, the second thermally conductive portion extends to overlap the rotating shaft in the thickness direction of the electronic device, to form a fourth heat transfer path of the second heat source, the heat dissipation plate, the second thermally conductive portion, and the rotating shaft. In this solution, inherent elements of the electronic device, for example, the rotating shaft, the rear cover, and the second middle frame, can be effectively used to transfer heat generated by the second component module and the battery, that is, the rotating shaft, the rear cover, and the second middle frame can participate in heat dissipation of the second component module. This provides heat dissipation for the battery, and improves heat dissipation efficiency of the electronic device.

In an implementation of the first aspect, the second circuit board and the second middle frame are connected through a thermally conductive medium, and the screen of the electronic device is disposed on a side that is of the heat dissipation plate and that faces away from the second circuit board. The second middle frame is disposed on a side that is of the second component module and that faces away from the screen, and the screen, the thermally conductive structure, the heat dissipation plate, the second heat source, the second circuit board, the thermally conductive medium, and the second middle frame can be sequentially disposed in a stacked manner. In this way, the first middle frame and the second middle frame may be used to replace a position and a function of the rear cover. That is, the first middle frame and the second middle frame of the electronic device are located at the position of the rear cover and serve as the rear cover, and each of the first middle frame and the second middle frame is disposed at an interval from a part of the screen to form an accommodation space. This helps ensure heat dissipation efficiency of the electronic device, and implement lightness and thinness of the electronic device.

In an implementation of the first aspect, a part of the thermally conductive structure is located between the heat dissipation plate and the screen, and a part of the thermally conductive structure is located between the rotating shaft and the screen. This can implement a first heat transfer path of the second heat source, the heat dissipation plate, the thermally conductive structure, and the rotating shaft and a second heat transfer path of the second heat source, the heat dissipation plate, the thermally conductive structure, and the screen. In this embodiment, the first middle frame and the second middle frame are disposed at the position of the rear cover of the electronic device, to replace the rear cover. This eliminates a space occupied by the rear cover in a thickness direction of the electronic device, can transfer, through an inherent element of the electronic device, heat generated by the second component module, and finally ensures passive heat dissipation efficiency of the second component module, and implements lightness and thinness of the electronic device.

In an implementation of the first aspect, a part of the thermally conductive structure is located between the second middle frame and the second circuit board, and a part of the thermally conductive structure is located between the battery and the second middle frame. In this way, a first heat transfer path of the second heat source, the second circuit board, the thermally conductive medium, a part of the thermally conductive structure, and the second middle frame may be formed, and a second heat transfer path of the battery, the other part of the thermally conductive mechanism, and the second middle frame may be formed, thereby expanding heat dissipation areas of the second component module and the battery, and helping improve heat dissipation efficiency of the electronic device.

In an implementation of the first aspect, the thermally conductive structure includes a third thermally conductive portion and a fourth thermally conductive portion. The third thermally conductive portion is located between the heat dissipation plate and the screen, and the fourth thermally conductive portion is located between the second circuit board and the second middle frame. The third thermally conductive portion extends to overlap the rotating shaft in the thickness direction of the electronic device, to form a first heat transfer path of the second heat source, the heat dissipation plate, the third thermally conductive portion, and the rotating shaft. Alternatively, the fourth thermally conductive portion extends to overlap the battery in the thickness direction of the electronic device, to form a second heat transfer path of a fourth heat transfer path of the battery, the fourth thermally conductive portion, and the second middle frame. In this embodiment, the fourth thermally conductive portion is laid between the battery and the second middle frame, so that two additional heat transfer paths are obtained. In this embodiment, lightness and thinness of the electronic device are ensured, and passive heat dissipation efficiency of the second heat source can be improved. In addition, the two heat transfer paths enable the rotating shaft and the second middle frame to participate in heat dissipation of the second component module and the battery, thereby expanding heat dissipation areas of the second component module and the battery, and helping improve heat dissipation efficiency of the electronic device.

In an implementation of the first aspect, the electronic device further includes a charging interface. The charging interface is located on a second side edge of the second middle frame, the second circuit board is adjacent to the second side edge, and the charging interface is electrically connected to the second circuit board. In this solution, the charging interface is integrated into the second circuit board, so that not only the second heat source is disposed on the second circuit board, but also the charging interface and a line connected to the charging interface are disposed. Alternatively, an electronic component electrically connected to the charging interface may be further disposed on the second circuit board. The integrated arrangement helps improve utilization of the space in the electronic device.

In an implementation of the first aspect, the electronic device further includes a stand and a stand rotating shaft. The stand and the stand rotating shaft are disposed on the second middle frame and located between the battery and the rotating shaft. The stand is connected to the stand rotating shaft, and the stand is capable of flipping relative to the second middle frame. The second component module and the stand are distributed on two sides of the stand rotating shaft. The stand and the battery are staggered in a length direction of the electronic device, and do not overlap. The stand rotating shaft and the battery are also disposed in a staggered manner, and do not overlap. In the thickness direction of the electronic device, the stand and the stand rotating shaft do not occupy a space of the battery in the thickness direction, thereby helping reduce a thickness of the electronic device. In an implementation, the rotating shaft and the stand rotating shaft can form a "T-shaped" layout and enclose the second heat source. The second heat dissipation assembly is configured to conduct heat from the second heat source to the stand rotating shaft and the rotating shaft. The architecture that has the "T-shaped" layout and that encloses the second heat source helps improve heat dissipation efficiency of the electronic device.

In an implementation of the first aspect, the electronic device further includes a third component module. A maximum size of the third component module in the thickness direction of the electronic device is less than a maximum size of the first component module in the thickness direction of the electronic device, and the third component module and the stand are disposed in a stacked manner in the thickness direction of the electronic device. The third component module has a small thickness, and therefore jointly occupies a thickness space of a region with the stand. This helps save the internal space of the electronic device, to implement lightness and thinness of the electronic device. In addition, the third component module and the stand are disposed in a stacked manner, the stand is connected to the stand rotating shaft, and the stand rotating shaft is connected to the second middle frame, so that heat generated by a functional component in the third component module can also be effectively dissipated through the stand, the stand rotating shaft, and the rotating shaft.

In an implementation of the first aspect, the third component module includes a third circuit board and an electronic component disposed on the third circuit board. The third circuit board is connected to the second middle frame, a support structure is disposed between the electronic component and the stand, and the support structure and the second middle frame jointly enclose the third component module. Therefore, in a flipping process of the stand, the third component module is not exposed. In addition, when the electronic device is in a folded state, isolation between the third component module and an outside can be enhanced.

In an implementation of the first aspect, a shielding structure is further disposed between the electronic component and the stand. The shielding structure is connected to the support structure, and the support structure, the shielding structure, and the stand are sequentially disposed in a stacked manner in the thickness direction of the electronic device. The shielding structure may be a metal sheet, and the shielding structure is configured to shield the support structure and may serve as a decorative member. The screen, the second middle frame, the third circuit board, the electronic component, the support structure, and the stand are sequentially disposed in a stacked manner in the thickness direction of the electronic device, that is, the support structure is disposed between the electronic component and the stand. The support structure can be configured to protect the third component module. The electronic component in the third component module is located between the support structure and the third circuit board, and the third component module and the electronic component are shielded and protected through the support structure, so that in the flipping process of the stand, the electronic component in the third component module is not exposed.

In an implementation of the first aspect, the electronic component on the third circuit board includes at least one of a capacitor, a resistor, or an inductor. In this way, the third component module has low load, thereby helping reduce an amount of heat generated by the electronic device.

In an implementation of the first aspect, the first heat source includes at least one of a CPU module or a power supply module; or the second heat source includes at least one of a charging management module, a battery management module, a DDR module, a radio frequency chip, an audio PA, a speaker management module, a screen TCON, or a screen management module. The CPU module or the power supply module can be configured to ensure implementation of a normal function of the electronic device. For example, the charging management module can be configured to be connected to an external power supply and provide a sufficient current for the CPU module or the power supply module. The DDR module, the radio frequency chip, the audio PA, or the screen TCON helps implement high performance of the electronic device.

In an implementation of the first aspect, the first heat dissipation assembly includes a vapor chamber and a fan. The vapor chamber is configured to conduct heat from the first heat source to a position of the fan. The first component module includes a first circuit board and the first heat source. The first heat source is located between the first circuit board and the vapor chamber in the thickness direction of the electronic device. There is a first spacing space between the first circuit board and the first middle frame, and there is a second spacing space between the vapor chamber and the rear cover of the electronic device. The screen of the electronic device is disposed on a side that is of the first middle frame and that faces away from the first circuit board. When the first component module has a heat dissipation requirement, the fan can draw external cold air into the first middle frame, that is, a first accommodation cavity, through an air intake vent disposed on a side that is of the screen and that is away from the rotating shaft. When flowing through the first heat source, the external cold air entering the first accommodation cavity can carry away the heat generated by the first heat source, and is discharged from the electronic device under action of a flow field through a plurality of air exhaust vents disposed on a second side edge and a first side edge of the first middle frame, to finally implement active heat dissipation for the first heat source.

In an implementation of the first aspect, the first heat dissipation assembly includes a cooling plate and a thermally conductive pad, and the first circuit board, the first heat source, the thermally conductive pad, the cooling plate, and the vapor chamber are sequentially disposed in a stacked manner in the thickness direction of the electronic device. The cooling plate and the thermally conductive pad are configured to improve heat dissipation efficiency on a heat dissipation path for active heat dissipation. In an implementation, the cooling plate may be made of copper. The thermally conductive pad may be thermally conductive gel or another type of thermally conductive medium.

In an implementation of the first aspect, the maximum size of the first heat source in the thickness direction of the electronic device is less than or equal to 2.5 mm; or the maximum size of the second heat source in the thickness direction of the electronic device is greater than or equal to 2 mm. In this embodiment, the first heat source with a small thickness occupies a small part of the internal space, of the electronic device, in which the first middle frame is located, and the second heat source with a large thickness and the first heat source are respectively disposed in two accommodation spaces on the two sides of the rotating shaft. This helps reduce a thickness difference between main bodies of the electronic devices on the two sides of the rotating shaft, and implement lightness and thinness of the electronic device.

In an implementation of the first aspect, the first middle frame is disposed between the rear cover and the screen of the electronic device in a stacked manner, and the first middle frame includes a bottom wall and a convex rib that are fastened. A through hole is disposed on the bottom wall. The convex rib is located on an outer side of the through hole, and the convex rib protrudes from the bottom wall toward the rear cover in the thickness direction of the electronic device. The first heat dissipation assembly is mounted on the convex rib, and at least a part of the heat dissipation assembly is located in the through hole. In this solution, the through hole is disposed on the bottom wall of the middle frame, and a bottom end of the heat dissipation assembly is built into the through hole, to form an embedded structure. Compared with a structure, in the conventional technology, in which the bottom end of the heat dissipation assembly directly laps with the bottom wall, the embedded structure can reduce an overall thickness of the electronic device. The convex rib protrudes in a direction away from the bottom wall in the thickness direction of the electronic device, and can enhance local strength of the bottom wall and improve stability. In addition, the convex rib is located on the outer side of the through hole, and may be further configured to be connected to the heat dissipation assembly, to implement mounting and locating functions for the heat dissipation assembly. This can prevent the heat dissipation assembly from shaking in a use process of the electronic device, and ensure mounting stability of the heat dissipation assembly.

In an implementation of the first aspect, the electronic device further includes a reinforcing member. The reinforcing member is fastened to an end that is of the bottom wall and that is away from the convex rib, and the reinforcing member covers the through hole. In this solution, the reinforcing member is fastened to the bottom wall, and can fully cover the through hole, to implement a local reinforcement function. This can enhance structural strength of the bottom wall around the through hole, thereby improving overall structural strength of the middle frame, and ensuring reliability of the screen.

In an implementation of the first aspect, a mounting groove is concavely disposed on a surface that is of the bottom wall and that faces away from the rear cover, and the reinforcing member is fastened in the mounting groove. Using the mounting groove to mount and fasten the reinforcing member helps implement a thin design of an overall structure, and can support the screen with good flatness.

In an implementation of the first aspect, the heat dissipation assembly includes a fan housing and a fan rotating mechanism. The fan housing includes an upper cover, a lower cover, and a side enclosure. The upper cover, the lower cover, and the side enclosure jointly enclose an accommodation space. The fan rotating mechanism is mounted in the accommodation space. The upper cover is provided with an air intake hole, and the side enclosure is provided with an air exhaust hole. The air intake hole and the air exhaust hole separately communicate with the accommodation space. In this solution, specific designs of the housing and the fan rotating shaft mechanism of the heat dissipation assembly are constrained, and a solution of arranging the air intake hole and the air exhaust hole is provided. This solution helps implement a thin design of the electronic device.

In an implementation of the first aspect, there is an air intake channel between the upper cover of the fan housing and the rear cover of the electronic device, and the air intake channel communicates with the air intake hole.

In an implementation of the first aspect, at least a part of the convex rib is disposed around the through hole, and the side enclosure of the fan housing is fastened to the convex rib.

In an implementation of the first aspect, the upper cover includes an upper cover flow-guiding portion, and the lower cover includes a lower cover flow-guiding portion. The upper cover flow-guiding portion and the lower cover flow-guiding portion are disposed opposite to each other in the thickness direction of the electronic device.

In an implementation of the first aspect, the lower cover further includes a lower cover body. The lower cover flow-guiding portion is connected to the lower cover body and is inclined relative to the lower cover body in a direction close to the upper cover.

In an implementation of the first aspect, the upper cover further includes an upper cover body. The upper cover flow-guiding portion is connected to the upper cover body and is inclined relative to the upper cover body in a direction away from the lower cover.

There is an included angle α between the lower cover flow-guiding portion and the lower cover body, and the included angle α meets 90°≤α≤170°.

In an implementation of the first aspect, the upper cover further includes an upper cover reinforcing portion. At least a part of the upper cover body is connected to the upper cover reinforcing portion, and the upper cover reinforcing portion protrudes relative to the upper cover body in a direction of the rear cover of the electronic device.

In an implementation of the first aspect, the upper cover body is provided with a connecting portion. The connecting portion is connected to the upper cover reinforcing portion. The connecting portion is disposed at each of two ends of the upper cover body in a width direction of the heat dissipation assembly, and the two connecting portions are separately fastened to the convex rib.

In an implementation of the first aspect, an edge of the lower cover includes a flat plate-shaped structure. The flat plate-shaped structure is close to an air exhaust vent. An edge region of the bottom wall of the first middle frame is adjacent to the air exhaust vent and is adjacent to the edge of the lower cover, and the edge region includes an air-guiding inclined surface. The air-guiding inclined surface is inclined and extends relative to the flat plate-shaped structure, and the air-guiding inclined surface is configured to guide air in the accommodation space of the fan housing from the air exhaust vent to an outside of the housing.

In an implementation of the first aspect, there is an air-guiding structure at an edge that is of the upper cover of the fan housing and that is adjacent to the air exhaust vent. The air-guiding structure includes a first part, a second part, and a third part that are sequentially connected. The second part is inclined and extends relative to the first part. A diameter of the light outlet corresponding to the third part is greater than a diameter of the air exhaust vent corresponding to the second part. The diameter of the air exhaust vent corresponding to the second part is in a gradually expanding form.

In an implementation of the first aspect, the first part is parallel to a surface of the flat plate-shaped structure of the lower cover, and an angle at which the second part is inclined relative to the first part is the same as an angle at which the air-guiding inclined surface is inclined relative to the flat plate-shaped structure.

In an implementation of the first aspect, the electronic device further includes a flexible circuit board. A groove is disposed at an end that is of the lower cover and that is away from the fan rotating mechanism, and at least a part of the flexible circuit board is mounted in the groove.

In an implementation of the first aspect, the heat dissipation plate is at least one of a metal plate, a heat sink structure with a heat dissipation fin, a vapor chamber, or a combination of a metal plate and a heat pipe; or the thermally conductive structure is a graphite sheet. This helps improve active heat dissipation efficiency of the first component module through the heat dissipation plate, and improve passive heat dissipation efficiency of the second component module through the thermally conductive structure, to finally implement efficient heat dissipation for the electronic device.

In an implementation of the first aspect, the electronic device further includes an electrical connection structure. The electrical connection structure passes through or crosses the rotating shaft and is electrically connected between the first component module and the second component module, to electrically connect the first component module and the second component module. In an implementation, the electrical connection structure is a flexible circuit board.

In an implementation of the first aspect, the electrical connection structure includes at least one layer of flexible circuit board. Two ends of the flexible circuit board are respectively connected to the first middle frame and the second middle frame. At least a part of a portion that is on the flexible circuit board and that is located between the first middle frame and the second middle frame is connected to the rotating shaft. At least one strip-shaped hole is disposed on the flexible circuit board. The strip-shaped hole extends in a second direction, and at least a part of the strip-shaped hole is located between the first middle frame and the second middle frame. The second direction is perpendicular to an axial direction of the rotating shaft. In this application, the strip-shaped hole is disposed on the flexible circuit board, so that a part that is on the flexible circuit board and that is located between a first fastening portion and a second fastening portion can be separated into a plurality of transmission segments with a small width, to avoid significant twisting of the flexible circuit board in a bending process, thereby prolonging a service life of the flexible circuit board.

In an implementation of the first aspect, the flexible circuit board is separated into a plurality of transmission segments by the strip-shaped hole. The plurality of transmission segments are parts that are on the flexible circuit board and that are located between the first middle frame and the second middle frame, and at least a part of the plurality of transmission segments have different widths in the axial direction of the rotating shaft. Edges that are of each transmission segment and that are connected to the first fastening portion and the second fastening portion have a small width in the second direction Y, and the width can be less than 15 mm, so that an amount of twisting deformation can be reduced or even no twisting is caused.

In an implementation of the first aspect, the rotating shaft includes a first door panel, a second door panel, a third door panel, and a hinge structure. The first door panel and the third door panel are located on two opposite sides of the second door panel. The hinge structure directly faces the second door panel. Both the first door panel and the third door panel are rotatably connected to the hinge structure. The electrical connection structure includes a flexible circuit board. Two ends of the flexible circuit board are respectively fastened to the first middle frame and the second middle frame. The electronic device further includes a limiting structure. The limiting structure is located on a side that is of the flexible circuit board and that faces the second door panel, and the limiting structure covers at least a part of a bendable portion. In this solution, in a process of opening/closing a foldable display device, the limiting structure can improve mechanical performance of the flexible circuit board, and can further limit a sudden form change of the flexible circuit board, thereby effectively suppressing a problem of a sudden form change in the process of opening/closing the foldable display device, and further alleviating a problem of an abnormal sound generated in the process of opening/closing the foldable display device.

In an implementation of the first aspect, the electronic device includes a first fastening portion and a second fastening portion. The first fastening portion fastens one end of the flexible circuit board to the first middle frame, and the second fastening portion fastens the other end of the flexible circuit board to the second middle frame. A part that is of the flexible circuit board and that is located between the first fastening portion and the second fastening portion has a segmentation slot. The bendable portion located on two opposite sides of the segmentation slot includes a first bendable portion and a second bendable portion. The limiting structure covers at least a part of the first bendable portion and at least a part of the second bendable portion.

A flexible circuit board with a segmentation slot is also referred to as a segmented flexible circuit board. For the segmented flexible circuit board, a bendable portion of each segment of flexible circuit board may undergo a sudden form change. The limiting structure covers at least a part of the first bendable portion and at least a part of the second bendable portion, so that the sudden form change of the bendable portion of each segment of flexible circuit board can be specifically limited.

In an implementation of the first aspect, the limiting structure includes a first limiting structure and a second limiting structure. The first limiting structure covers at least a part of the first bendable portion, and the second limiting structure covers at least a part of the second bendable portion. The first limiting structure and the second limiting structure are integrally connected. For the segmented flexible circuit board, two segments of flexible circuit boards on two sides of the segmentation slot may have different widths, and form changes of different segments may be different in the process of opening/closing the foldable display device. In this way, the first limiting structure and the second limiting structure may respectively limit form changes of the first bendable portion and the second bendable portion. The first limiting structure and the second limiting structure are connected as an integrated design, to facilitate processing and mounting of the limiting structure.

In an implementation of the first aspect, the flexible circuit board includes a first flexible substrate and a second flexible substrate that are disposed in a stacked manner. The first flexible substrate is closer to the second door panel than the second flexible substrate. In the bendable portion, an elastic modulus of the first flexible substrate is less than an elastic modulus of the second flexible substrate. Rigidity of an inner layer is less than rigidity of an outer layer, to better adapt to a different bending radius of each layer, and better limit a sudden form change of the flexible circuit board in cooperation with the limiting structure.

In an implementation of the first aspect, the flexible circuit board further includes a third flexible substrate. The second flexible substrate is located between the first flexible substrate and the third flexible substrate. In the bendable portion, the elastic modulus of the second flexible substrate is less than or equal to an elastic modulus of the third flexible substrate. Such a design helps implement a constraint on the sudden form change of the flexible circuit board. The rigidity of the inner layer is less than rigidity of a middle layer and the rigidity of the outer layer, the rigidity of the middle layer is less than the rigidity of the outer layer, and a gradient distribution is used for rigidity of different layers of the flexible circuit board, to better limit the sudden form change of the flexible circuit board in cooperation with the limiting structure.

In an implementation of the first aspect, the electronic device further includes a support member, a first antenna sub-portion, and a second antenna sub-portion, and all of the support member, the first antenna sub-portion, and the second antenna sub-portion are disposed in the internal space, of the electronic device, in which the first middle frame is located. An inner cavity and an air duct are formed between the rear cover of the electronic device and the first middle frame. Both the support member and the first circuit board are mounted in the inner cavity. The first antenna sub-portion is fastened to a side that is of the support member and that faces the rear cover and is electrically connected to the first circuit board, to feed the first antenna sub-portion. The second antenna sub-portion is fastened to a surface that is of the rear cover and that faces the middle frame. A region that is of the rear cover and that directly faces the second antenna sub-portion is a non-signal shielding region. An antenna signal is transmitted between the first antenna sub-portion and the second antenna sub-portion through coupling.

According to a second aspect, an implementation of this application provides an electronic device, including a middle frame, a rear cover, a support member, a circuit board, a first antenna sub-portion, and a second antenna sub-portion. The rear cover is fastened to one side of the middle frame, and an inner cavity and an air duct are formed between the rear cover and the middle frame. Both the support member and the circuit board are mounted in the inner cavity. The first antenna sub-portion is fastened to a side that is of the support member and that faces the rear cover and is electrically connected to the circuit board, to feed the first antenna sub-portion. The second antenna sub-portion is fastened to a surface that is of the rear cover and that faces the middle frame. A region that is of the rear cover and that directly faces the second antenna sub-portion is a non-signal shielding region. An antenna signal is transmitted between the first antenna sub-portion and the second antenna sub-portion through coupling.

In this implementation, in this solution, the second antenna sub-portion is at least partially located on an inner surface of the rear cover and can transmit a signal through the rear cover, and an antenna radiator is disposed through the rear cover. In this way, the second antenna sub-portion does not occupy a space of the air duct, and a circulation area of an air exhaust channel of a fan can be ensured. Therefore, in this solution, heat dissipation performance of an antenna can be ensured, and the air duct of the electronic device provides a good clearance environment for the antenna, which helps ensure performance of the antenna. Therefore, in this solution, radiation performance of the antenna can also be ensured, and the antenna can have better bandwidth and radiation efficiency.

A feed circuit is disposed on the circuit board, and the feed circuit may feed the first antenna sub-portion.

The non-signal shielding region may be made of a non-conductive material. The non-conductive material may be glass fiber, ceramic, plastic, or the like.

In some possible implementations, the second antenna sub-portion is a flexible printed circuit board or a metal part. In this case, the second antenna sub-portion has a simple structure and is easy to implement.

In some possible implementations, the second antenna sub-portion is a conductive heat dissipation member. In this implementation, the electronic device reuses the heat dissipation member as the second antenna sub-portion. In this way, not only a heat dissipation function of the heat dissipation member can be retained, but also the air duct can carry away heat from the heat dissipation member, to carry away heat from another component thermally connected to the heat dissipation member in the electronic device, so as to ensure heat dissipation performance of the electronic device. In addition, antenna performance of the electronic device can be improved without adding an additional structural member. Therefore, implementation difficulty is low, and costs are low.

For example, the second antenna sub-portion may be a graphite sheet. The graphite sheet is easy to cut, making it easier to meet a heat dissipation requirement and an antenna design requirement, and has low costs. The graphite sheet may be assembled and fastened to the rear cover through bonding or in another manner.

### BRIEF DESCRIPTION OF DRAWINGS

FIG. 1 is a diagram of a structure of an electronic device in an unfolded state according to an embodiment of this application;
FIG. 2 is a diagram of a structure of an electronic device in a folded state according to an embodiment of this application;
FIG. 3 is a diagram of a top-view structure of an electronic device that is in an unfolded state and that is not provided with a rear cover according to an embodiment of this application;
FIG. 4 is a diagram of a cross-sectional structure of the electronic device shown in FIG. 2;
FIG. 5 is a diagram of a cross-sectional structure of an electronic device according to an embodiment of this application;
FIG. 6 is another diagram of a cross-sectional structure of an electronic device according to an embodiment of this application;
FIG. 7 is another diagram of a cross-sectional structure of an electronic device according to an embodiment of this application;
FIG. 8 is another diagram of a cross-sectional structure of an electronic device according to an embodiment of this application;
FIG. 9 is a diagram of a cross-sectional structure of an electronic device in an unfolded state according to an embodiment of this application;
FIG. 10 is another diagram of a cross-sectional structure of an electronic device in an unfolded state according to an embodiment of this application;
FIG. 11 is another diagram of a top-view structure of an electronic device that is in a flattened state and that is not provided with a rear cover according to an embodiment of this application;
FIG. 12 is a diagram of a cross-sectional structure of the electronic device shown in FIG. 11 in a folded state;
FIG. 13 is a cross-sectional view of an electronic device according to an embodiment of this application;
FIG. 14 is a cross-sectional view of the electronic device in FIG. 13 from another perspective;
FIG. 15 is a top view of an internal structure of the electronic device in FIG. 13;
FIG. 16 is a three-dimensional diagram of a part combining a first middle frame and a fan in an electronic device in a direction according to an embodiment of this application;
FIG. 17 is a three-dimensional diagram of a part combining a first middle frame and a fan in an electronic device in another direction according to an embodiment of this application;
FIG. 18 is a three-dimensional exploded view of a part combining a first middle frame and a fan in an electronic device in a direction according to an embodiment of this application;
FIG. 19 is a three-dimensional exploded view of a part combining a first middle frame and a fan in an electronic device in another direction according to an embodiment of this application;
FIG. 20 is a cross-sectional view of an assembly structure combining a first middle frame and a fan according to an implementation of this application;
FIG. 21 is an enlarged view of a part I in FIG. 20;
FIG. 22 is a partial view of an electronic device in a flattened state according to an embodiment of this application;
FIG. 23 is a diagram of a structure of a flexible circuit board according to an embodiment of this application;
FIG. 24A is a state diagram of a flexible circuit board during application according to an embodiment of this application;
FIG. 24B is another state diagram of a flexible circuit board during application according to an embodiment of this application;
FIG. 25 is a simulation diagram of a bending life of a flexible circuit board according to this application;
FIG. 26 is a diagram of an electronic device according to an implementation of this application;
FIG. 27 is a diagram of a two-dimensional structure of a foldable display device that is in an unfolded state and to which a limiting structure is added according to an embodiment of this application, where a flexible circuit board of the foldable display device includes a segmentation slot;
FIG. 28A is a diagram of a two-dimensional structure of a foldable display device from another angle according to an implementation of this application, where sizes of three limiting structures may be different;
FIG. 28B is a diagram of another implementation of the limiting structure in FIG. 28A; and
FIG. 29 is a diagram of a partial structure of an electronic device according to an implementation of this application.

### DESCRIPTION OF EMBODIMENTS

Explanation of some terms:
CPU: central processing unit, central processing unit;
PA: power amplifier, power amplifier;
TCON: timing controller, timing controller;
DDR: double data rate synchronous dynamic random access memory, double data rate synchronous dynamic random access memory;
VC: vapor chamber, vapor chamber;
active heat dissipation: A fan or another device (for example, a pump) is used for direct forced convection, to accelerate transfer of heat from a heat source (for example, a chip) to an external environment; and
passive heat dissipation: Heat is dissipated from a surface of a device to an environment through natural convection or radiation based on thermal conductivity of a material.

The following explains and describes some terms in embodiments of this application.

In the specification, claims, and accompanying drawings of embodiments of this application, the terms "first", "second", "third", "fourth", and the like are used to distinguish between similar objects, and are not necessarily used to describe a specific sequence or order. It should be understood that data used in this way is interchangeable in appropriate situations, so that embodiments of this application described herein can be implemented in a sequence different from that illustrated or described herein. In addition, the terms "include" and "have" and any other variants thereof are intended to cover a non-exclusive inclusion. For example, a process, method, system, product, or device that includes a list of steps or units is not necessarily limited to those expressly listed steps or units, but may include other steps or units not expressly listed or inherent to such a process, method, product, or device.

This application provides an electronic device. The electronic device may be any foldable terminal device such as a foldable-screen smartphone or a foldable PC. The electronic device has two main bodies that can be folded and unfolded relative to each other, so that the electronic device can be used in a folded state and a flattened state. The electronic device has a foldable screen, that is, the screen is in a flexible and foldable state. In the folded state, the screen is relatively folded, and the electronic device has a small volume and is easy to carry. In the flattened state, the screen is in a flattened large-screen state, and has good display effect. In the flattened state, a thickness difference between the two main bodies of the electronic device is small, which helps present advantages of being light, thin, aesthetically pleasing, and convenient for use. If the thickness difference between the two main bodies is large, in the flattened state, one side of the screen is heavy and the other side is light, affecting user comfort and resulting in poor user experience.

In an implementation, a rotating shaft mechanism of the electronic device is connected to a first housing and a second housing, and can enable the first housing to be unfolded or folded relative to the second housing. The first housing, the second housing, and the rotating shaft mechanism jointly carry a flexible display screen (namely, the foldable screen) of the electronic device.

A layout of a component in the electronic device affects a thickness of the electronic device. To control the thickness difference between the two relatively foldable main bodies of the electronic device within a small range, in embodiments of this application, components with different load levels and different heights are respectively arranged in internal spaces of the two main bodies on two opposite sides of a rotating shaft based on respective heat dissipation requirements (or space requirements), to fully use an overall space. In this way, the thickness difference between the two main bodies is within an appropriate range, to obtain an aesthetically pleasing, light, and thin electronic device, thereby improving use comfort and experience.

In an implementation, in embodiments of this application, a mainboard and a component on the mainboard are disposed on one of middle frames, and a component with a high height and a component with a low load level (this type of component has a high height, but has low power, and does not require active heat dissipation, and passive heat dissipation may meet a working requirement of the component) are disposed on another middle frame. In this way, an overall thickness of a main body, of the electronic device, in which the mainboard is located is reduced, and the thickness difference between the two main bodies is reduced. This can properly control an overall thickness size of the electronic device and improve user experience while meeting a heat dissipation requirement.

Specifically, in an implementation, functional components in the electronic device include a first-type component (a component that has high load and whose size is a medium height), a second-type component (a component that has medium load and whose size is a high height), and a third-type component (a component that has low load and whose size is a low height). The high load, the medium load, or the low load herein means relative comparison between power and a heat dissipation parameter of the component in a working state. The medium height, the high height, or the low height herein means a space size occupied by the component in a thickness direction of the electronic device. In an implementation, in embodiments of this application, the first-type component is disposed in a space of a main body in which a first middle frame is located, and active heat dissipation is used. The second-type component is disposed in a space of a main body in which a second middle frame is located, and passive heat dissipation is used. The third-type component is disposed in the space of the main body in which the second middle frame is located, and is arranged below a built-in stand. The built-in stand and a battery do not overlap, and passive heat dissipation is also used. For example, the first-type component includes but is not limited to a CPU module, a power supply module, and the like. The second-type component includes at least one of a charging management module, a DDR module, a radio frequency chip, an audio PA, or a screen TCON. The third-type component may be at least one of a resistor, a capacitor, an inductor, or the like.

In this application, the second-type component (a component whose size is a high height) and the first-type component (a component whose size is a medium height) are distributed in spaces in which different middle frames on two the sides of the rotating shaft are located, active heat dissipation is performed for the first-type component, and passive heat dissipation is performed for the second-type component. For active heat dissipation, a heat dissipation structure needs a large space, and a heat dissipation structure for passive heat dissipation does not need a large space. Therefore, in this application, the first-type component that requires active heat dissipation and whose size is a medium height is disposed in a space in which one middle frame is located, and passive heat dissipation is performed for the second-type component with a high height in a space in which another middle frame is located, so that the thickness difference between the main bodies of the electronic device that correspond to the two middle frames can be within an appropriate small range. On the contrary, if both the first-type component and the second-type component are disposed in a space in which a same middle frame is located, a thickness of a body corresponding to the middle frame is definitely larger, and a thickness of another middle frame is smaller, resulting in a larger thickness difference between the two middle frames.

The electronic device in embodiments of this application may alternatively be a tablet computer, a notebook computer, a handheld device with a wireless communication function, a compute device, another processing device connected to a wireless modem, a vehicle-mounted device, an electronic device in a 5G network, an electronic device in a future evolved public land mobile network (public land mobile network, PLMN), or the like.

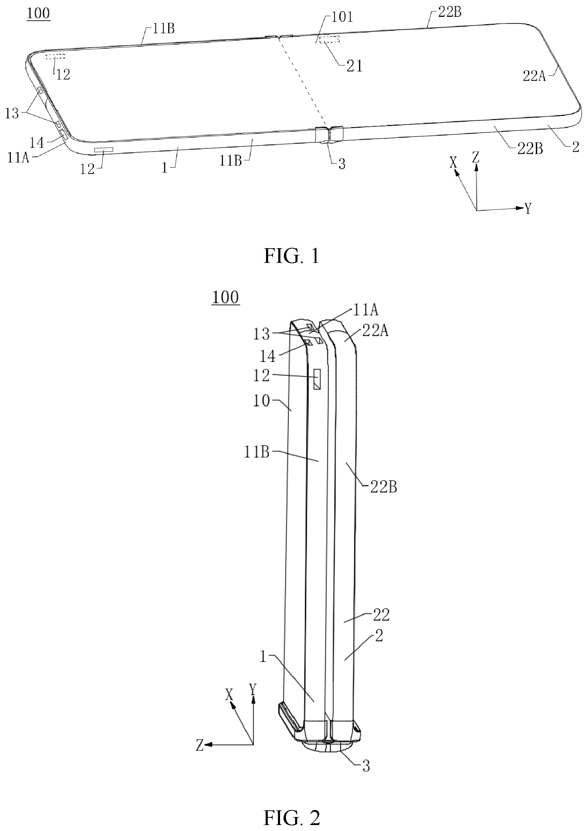

FIG. 1 is a diagram of a structure of an electronic device 100 in an unfolded state according to an embodiment of this application. FIG. 2 is a diagram of a structure of an electronic device 100 in a folded state according to an embodiment of this application. With reference to FIG. 1 and FIG. 2, the electronic device 100 includes a first middle frame 1, a second middle frame 2, a rotating shaft 3, and a rear cover 10. Both the first middle frame 1 and the second middle frame 2 may be configured to carry functional components in the electronic device 100, for example, a central processing unit, a circuit board, a charging module, and a battery. The first middle frame 1 and the second middle frame 2 are respectively located on two sides of the rotating shaft 3 and are connected to the rotating shaft 3, and the first middle frame 1 and the second middle frame 2 can be opened and closed through the rotating shaft 3. One part of the rear cover 10 is disposed on the first middle frame 1 and forms a first accommodation cavity with the first middle frame 1 through enclosing, and the other part of the rear cover 10 is disposed on the second middle frame 2 and forms a second accommodation cavity with the second middle frame 2 through enclosing. Both the first accommodation cavity and the second accommodation cavity can be used to accommodate functional components in the electronic device 100.

With reference to FIG. 1 and FIG. 2, in this embodiment of this application, a direction of an axis of the rotating shaft 3 of the electronic device 100 is a first direction X, and a length direction of the electronic device 100 is a second direction Y, or a length direction of the first middle frame 1 and a length direction of the second middle frame 2 are a second direction Y. The second direction Y is perpendicular to the first direction X. All of a thickness direction of the electronic device 100, a thickness direction of the first middle frame 1, and a thickness direction of the second middle frame 2 are a third direction Z. The third direction Z is perpendicular to a plane formed by the first direction X and the second direction Y. A length, a width, and a thickness in embodiments of this application are merely for ease of description, and do not mean any limitation on a size. For example, the length may be greater than, equal to, or less than the width.

With reference to FIG. 1, the first middle frame 1 and the second middle frame 2 can be unfolded relative to each other to a flattened state. When the electronic device 100 is in the flattened state, a screen 101 of the electronic device 100 is in the flattened state, and a display interface can be presented to a maximum extent. In the flattened state, the electronic device 100 may be handheld to perform an operation, or the electronic device may be supported through a stand in any available placement region such as on a desktop without being handheld, to help a user perform an operation on the electronic device 100.

With reference to FIG. 2, the first middle frame 1 and the second middle frame 2 can be closed relative to each other to a folded state. When the electronic device 100 is in the folded state, the electronic device 100 is portable and is convenient to carry.

As shown in FIG. 1 and FIG. 2, in a possible implementation, the electronic device 100 is a bi-fold device, and includes two main bodies that can be folded and unfolded relative to each other. That is, there may be one first middle frame 1, one rotating shaft 3, and one second middle frame 2, and the rotating shaft 3 may be located between the first middle frame 1 and the second middle frame 2. When the electronic device 100 is in the folded state, the first middle frame 1 and the second middle frame 2 are folded relative to each other to be in a two-layer state (as shown in FIG. 2). In the implementation shown in FIG. 2, the electronic device 100 is an inward foldable device, and in the folded state, the screen 101 is located between the first middle frame 1 and the second middle frame 2. In another implementation, the electronic device 100 may be a tri-fold device. The electronic device includes three middle frames, and any adjacent middle frames may be connected through a rotating shaft. In a specific implementation, the tri-fold electronic device may be folded into an S shape or a G shape in the folded state.

As shown in FIG. 1 and FIG. 2, in a possible implementation, a frame, of the electronic device, corresponding to the first middle frame 1 includes a first side edge 11A and a second side edge 11B. The first side edge 11A is parallel to the rotating shaft 3. There are two second side edges 11B. The two second side edges are disposed opposite to each other and connected between the rotating shaft 3 and the first side edge 11A. In an implementation, an air intake vent 12 and an air exhaust vent 13 are disposed on the frame of the electronic device 100. The air intake vent 12 is located on the second side edge 11B, and the air intake vent 12 is located at a position that is on the second side edge 11B and that is close to the first side edge 11A. In an implementation, there are two air intake vents 12 of the electronic device 100, and one air intake vent 12 is disposed on each second side edge 11B. The air exhaust vent 13 is located on the first side edge 11A. In an implementation, there are two air exhaust vents 13, and the two air exhaust vents 13 are disposed on the first side edge 11A at an interval. The air intake vent 12 and the air exhaust vent 13 have different opening directions, but are adjacent to each other, and both may be disposed at positions close to a position at which a fan in the electronic device 100 is located. This helps ensure air flow exchange between an inside of the electronic device 100 and an outside, implements efficient heat dissipation for a plurality of heat-generating functional components, and helps ensure long-term and efficient running of the electronic device 100. In an implementation, directions of the two air exhaust vents 13 of the electronic device 100 are the same. For example, the directions of both the two air exhaust vents 13 are the second direction Y.

With reference to FIG. 1 and FIG. 2, in a possible implementation, the electronic device 100 is provided with a first charging interface 14 and a second charging interface 21. Optionally, the first charging interface 14 is disposed on the first side edge 11A, and the second charging interface 21 is disposed on a frame, of the electronic device, corresponding to the second middle frame 2. Specifically, the frame, of the electronic device, corresponding to the second middle frame 2 includes a third side edge 22A and a fourth side edge 22B. The third side edge 22A is parallel to the rotating shaft 3, and there are two fourth side edges 22B. The two fourth side edges are disposed opposite to each other and connected between the rotating shaft 3 and the third side edge 22A. The fourth side edge 22B is in the second direction Y (that is, extends in the length direction of the electronic device 100). The second charging interface 21 is disposed at a position that is on the fourth side edge 22B and that is close to the rotating shaft 3, that is, a distance between the second charging interface 21 and the rotating shaft 3 is less than a distance between the second charging interface 21 and the third side edge 22A. The first charging interface 14 and the second charging interface 21 may be separately configured to receive an external power supply, to charge a functional component in the electronic device. In an implementation, the first charging interface 14 and the second charging interface 21 may be used interchangeably, and functions of the first charging interface 14 and the second charging interface 21 are the same. The first charging interface 14 or the second charging interface 21 that is convenient for plugging in a charger may be selected based on different use states of the electronic device. In an implementation, positions of the first charging interface 14 and the second charging interface 21 may be determined based on distribution of electronic elements inside the first middle frame 1 and the second middle frame 2. Properly setting the positions of the first charging interface 14 and the second charging interface 21 helps improve component integration of the electronic device 100, thereby saving an internal space of the electronic device 100. In another implementation, the electronic device 100 may be provided with only one charging interface.

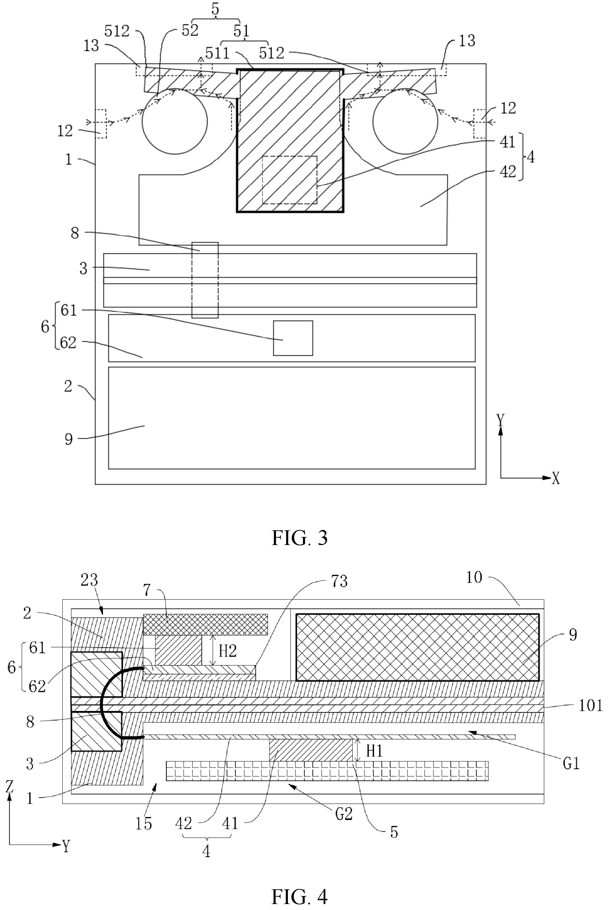

FIG. 3 is a diagram of a top-view structure of an electronic device 100 that is in an unfolded state and that is not provided with a rear cover 10 according to an embodiment of this application. FIG. 4 is a diagram of a cross-sectional structure of the electronic device 100 shown in FIG. 2. With reference to FIG. 3 and FIG. 4, the electronic device 100 provided in this embodiment of this application includes a first component module 4, a first heat dissipation assembly 5, a second component module 6, a second heat dissipation assembly 7, an electrical connection structure 8, and a battery 9. Each of the first component module 4 and the second component module 6 includes a circuit board and a functional component, a packaging structure, a shielding structure, and the like that are disposed on the circuit board. In an implementation, the first component module 4 is a first-type component (a component that has high load and whose size is a medium height), and the second component module 6 is a second-type component (a component that has medium load and whose size is a high height). The first component module 4 and the second component module 6 are distributed in two main bodies on two sides of the rotating shaft of the electronic device. The first heat dissipation assembly 5 provides active heat dissipation for the first component module 4, and the second heat dissipation assembly 7 provides passive heat dissipation for the second component module 6. Each of the first heat dissipation assembly 5 and the second heat dissipation assembly 7 may include a specific structural member in the electronic device, for example, a rotating shaft, a middle frame, a rear cover, and a shielding cover of a component. These structures have materials with high heat conduction efficiency, and all may be used as a part of the heat dissipation assembly. The electrical connection structure 8 is configured to electrically connect the first component module 4 and the second component module 6. Specifically, in FIG. 3, the electrical connection structure 8 is represented by using a rectangular box, and in FIG. 4, the electrical connection structure 8 is represented by using a thick line. The electrical connection structure 8 can pass through or cross the rotating shaft 3 and electrically connects the first component module 4 and the second component module 6. In an implementation, the electrical connection structure 8 is an FPC (flexible circuit board).

In an implementation, the electronic device includes a first circuit board, a second circuit board, and a flexible circuit board. The first circuit board is located in a first housing (a housing, of the electronic device, corresponding to the first middle frame 1). A first heat-generating member is electrically connected to the first circuit board, and the first heat-generating member may be a first heat source. The first heat-generating member and the first circuit board jointly form the first component module 4. The second circuit board is located in a second housing (a housing, of the electronic device, corresponding to the second middle frame 2), and the second circuit board and a second heat-generating member (which may be a second heat source) jointly form the second component module 6. The flexible circuit board (that is, the electrical connection structure 8) electrically connects the first circuit board and the second circuit board.

With reference to FIG. 3 and FIG. 4, both the first component module 4 and the first heat dissipation assembly 5 are disposed on the first middle frame 1. Specifically, both the first component module 4 and the first heat dissipation assembly 5 are located in a first accommodation cavity 15 formed by the rear cover 10 and the first middle frame 1 through enclosing. The first component module 4 includes a first heat source 41. For example, the first heat source 41 may include but is not limited to a CPU module or a power supply module. Optionally, a maximum size of the first heat source 41 in the thickness direction of the electronic device 100 is less than or equal to 2.5 mm, and the size of the first heat source 41 in the thickness direction of the electronic device 100 includes a structure such as a functional component (for example, a part of a chip or a circuit), a packaging structure, or a screen cover of the first heat source 41. The first heat dissipation assembly 5 may include but is not limited to a fan, a liquid cooling component, or the like. The first heat dissipation assembly 5 can be configured to perform active heat dissipation for the first component module 4. In an implementation, the first heat dissipation assembly 5 includes a vapor chamber 51 and a fan 52. A part of the vapor chamber 51 and the first heat source 41 are disposed in a stacked manner in the thickness direction of the electronic device 100. The fan 52 may be disposed at a position adjacent to the air exhaust vent 13. In a possible implementation, there are two fans 52 in the electronic device 100, that is, one air intake vent 12 and one air exhaust vent 13 are disposed near any fan 52. In an implementation, the vapor chamber 51 includes a first part 511 and a second part 512 that are connected. The first part 511 is connected to the first heat source 41, and the second part 512 is connected to the fan 52. A quantity of second parts 512 is set in a one-to-one correspondence with a quantity of fans 52. For example, in an implementation, there are two fans 52, there are two second parts 512, and the two second parts 512 are distributed on two opposite sides of the first part 511 in the first direction X (namely, a width direction of the electronic device 100). As shown in FIG. 3, the vapor chamber 51 is roughly in a T shape.

With reference to FIG. 3, in an implementation, an active heat dissipation solution is formed by combining the vapor chamber 51 and the fan 52. The vapor chamber 51 includes a hot end and a cold end. For example, a part that is of the first part 511 and that is in contact with the first heat source 41 is the hot end, and a position that is of the second part 512 and that is adjacent to the fan 52 is the cold end. When the first heat source 41 works, because the first heat source 41 has high power and generates a large amount of heat, for example, a temperature of the first heat source 41 in a working state may exceed 50 degrees, heat energy of the first heat source 41 is transferred to the hot end of the vapor chamber 51, so that a medium in the vapor chamber 51 is heated and vaporized. The vaporized medium diffuses to the cold end in the vapor chamber 51, and is cooled to a liquid state at the cold end (for example, at a position of the fan 52). The liquid medium is driven to the hot end through a structure (for example, a capillary structure) in the vapor chamber 51, to form cyclic heat dissipation.

With reference to FIG. 3 and FIG. 4, all of the second component module 6, the second heat dissipation assembly 7, and the battery 9 are disposed in a second accommodation cavity 23 formed by the rear cover 10 and the second middle frame 2 through enclosing. Optionally, the second component module 6 and the second heat dissipation assembly 7 are disposed in a stacked manner in the third direction Z (the thickness direction of the electronic device 100). The second component module 6 and the battery 9 are disposed side by side in the second direction Y (the length direction of the electronic device 100), the second component module 6 and the battery 9 do not overlap, and in the thickness direction of the electronic device, there is no overlapping region between the second component module 6 and the battery 9. In an implementation, the second component module 6 and the battery 9 may be in contact with each other. In an implementation, a gap may be retained between the second component module 6 and the battery 9. The gap between the second component module 6 and the battery 9 may be filled with an elastic structure, for example, foam. The elastic structure may absorb a size change caused by thermal expansion of the second component module 6 and the battery 9. The second heat dissipation assembly 7 may be fastened to the circuit board, or may be fastened to the second middle frame 2 through a fastener (for example, a screw). For example, by fastening the second heat dissipation assembly 7 and the second middle frame 2, a position of the second component module 6 can be fastened (clamped and fastened between the second heat dissipation assembly and the second middle frame through stacking).

In an implementation, the second component module 6 is disposed at a position that is in the second middle frame 2 and that is adjacent to the rotating shaft 3, and the second component module 6 is located between the battery 9 and the rotating shaft 3 in the second direction Y (the length direction of the electronic device 100). The second component module 6 includes a second heat source 61, and the second heat source 61 may be the second heat-generating member located in the second housing (the housing, of the electronic device, corresponding to the second middle frame 2). For example, the second heat source 61 includes at least one of a charging management module, a battery management module, a DDR module, a radio frequency chip, an audio PA, a speaker management module, a screen TCON, or a screen management module. In an implementation, the second heat source 61 is a charging management module or the like. Optionally, a maximum size of the second heat source 61 in the thickness direction of the electronic device 100 is greater than or equal to 2 mm, and the size of the second heat source 61 in the thickness direction of the electronic device 100 includes a structure such as a functional component (a chip), a packaging structure, or a screen cover of the second heat source 61. The second heat dissipation assembly 7 can be configured to perform passive heat dissipation for the second heat source 61 in the second component module 6. For example, the second heat dissipation assembly 7 has a material with high heat conduction efficiency, for example, metal or a graphite sheet. The second heat dissipation assembly 7 can be configured to conduct heat from the second heat source 61 to a component such as a circuit board, a middle frame, a thermally conductive structure, a heat dissipation plate, or the rotating shaft 3 of the electronic device 100. The heat is transferred on these components toward a region with low heat, to implement passive heat dissipation for the second heat source 61.

In this application, a feature of isolation between system spaces corresponding to an upper screen and a lower screen (namely, parts of the screen that respectively corresponding to the two middle frames) of the electronic device having a foldable function is used, and some heat-generating components, namely, the second heat source 61, are arranged on a circuit board in the system space corresponding to the lower screen, to reduce power consumption of the system space corresponding to the upper screen.

Specifically, in this application, a distributed heat source architecture is used, and the first heat source 41 (for example, a CPU and a power supply circuit thereof, and a DDR and a power supply circuit thereof), a fan, and the like are arranged in a system space corresponding to the first middle frame (namely, a system space on a main screen side). The second heat source (for example, a charging sub-board, a charging management module, a battery management module, or a screen TCON driver board) is arranged in a system space corresponding to the second middle frame. In this application, a heat dissipation solution in which air-cooling heat dissipation is mainly used and natural heat dissipation is used as a supplement may be used for the system space on the main screen side. Air-cooling heat dissipation may also be understood as active heat dissipation. For example, for air-cooling heat dissipation, a heat dissipation solution in which a fan is combined with a VC or a heat dissipation solution in which a pump and an amplifier are combined with a VC may be used. Heat on the mainboard is carried to an air exhaust region through a heat equalization function of the VC, and the heat is blown away by the fan (or by the pump and the amplifier).

In this embodiment of this application, at least one of the battery management module, the speaker management module, or the screen management module is disposed in the second housing (the housing, of the electronic device, corresponding to the second middle frame 2), so that heat-generating members (the first heat source 41 and the second heat source 61) are distributed in the first housing and the second housing. For example, the first heat-generating member (namely, the first heat source 41) is located in the first housing, and the second heat-generating member (namely, the second heat source 61) is located in the second housing, to avoid a problem that a heat dissipation capability of the second housing is not fully used because the first housing is overheated when the first heat-generating member and the second heat-generating member are concentrated in the first housing, and consequently an overall heat dissipation effect of the electronic device is affected.

With reference to FIG. 4, in an embodiment, a maximum size of the first component module 4 in the third direction Z is less than a maximum size of the second component module 6 in the third direction. The first component module 4 includes a first circuit board 42 and a first heat source 41 disposed on the first circuit board 42. A sum of a thickness of the first circuit board 42 and a maximum size H1 of the first heat source 41 in the third direction Z (namely, the thickness direction of the electronic device 100) is equal to the maximum size of the first component module 4 in the third direction Z. The second component module 6 includes a second circuit board 62 and a second heat source 61 disposed on the second circuit board 62. A sum of a thickness of the second circuit board 62 and a maximum size H2 of the second heat source 61 in the third direction Z (namely, the thickness direction of the electronic device 100) is equal to the maximum size of the second component module 6 in the third direction Z.

With reference to FIG. 4, in an embodiment, the maximum size H1 of the first heat source 41 in the third direction Z (namely, the thickness direction of the electronic device 100) is less than the maximum size H2 of the second heat source 61 in the third direction Z (namely, the thickness direction of the electronic device 100). For example, the first heat source 41 may include a plurality of functional components, and the second heat source 61 may also include a plurality of functional components. A thickness of a functional component that has a largest size in the third direction Z and that is in the first heat source 41 is less than a thickness of a functional component that has a largest size in the third direction Z and that is in the second heat source 61. In this implementation, only the functional component that has a largest size in the first direction Z needs to be constrained. It may be understood that the second heat source 61 may include a functional component with a small size, and sizes of some functional components in the first heat source 41 in the third direction Z may be greater than sizes of some functional components in the second heat source 61 in the third direction Z.

With reference to FIG. 4, power of the first heat source 41 is greater than power of the second heat source 61, that is, an amount of heat generated per unit time by the first heat source 41 in a working state is greater than an amount of heat generated per unit time by the second heat source 61 in a working state. Active heat dissipation needs to be performed for the first heat source 41 through the first heat dissipation assembly 5. Because the first heat source 41 generates a large amount of heat in the working state, if the heat from the first heat source 41 is directly conducted to the screen or the rear cover of the electronic device, local overheating of the electronic device is caused, which affects use experience (for example, the electronic device is hot), and further affects normal working of the screen. Therefore, the first heat source 41 requires active heat dissipation. In a specific implementation, in the thickness direction of the electronic device 100, there is a first spacing G1 between the first middle frame 1 and an end that is of the first component module 4 and that is away from the rear cover 10. Thermal isolation between the first heat source 41 and the first middle frame 1 is formed through the first spacing G1, to avoid a case in which a position that is of the first middle frame 1 and that corresponds to the first heat source 41 is overheated because heat is conducted to the first middle frame 1, and consequently a life and display of the screen 101 are affected. In the thickness direction of the electronic device 100, there is a second spacing G2 between the rear cover 10 and an end that is of the first component module 4 and that is away from the first middle frame 1. Thermal isolation between the first heat source 41 and the rear cover 10 is formed through the second spacing G2, to avoid a case in which a position that is of the rear cover 10 and that corresponds to the first heat source 41 is overheated because heat is conducted to the rear cover 10, and consequently user experience is affected (for example, the electronic device is hot). Therefore, in addition to a space occupied by the first component module 4 in the first accommodation cavity 15 in the thickness direction of the electronic device 100, the first spacing G1 and the second spacing G2 also need to occupy additional spaces in the first accommodation cavity 15 in the thickness direction of the electronic device 100.

With reference to FIG. 4, a heat dissipation requirement of the second heat source 61 is lower than a heat dissipation requirement of the first heat source 41, and the heat dissipation requirement of the second heat source 61 can be met by performing passive heat dissipation for the second heat source 61. Passive heat dissipation requires the second component module 6 and the second heat dissipation assembly 7 to be attached to a housing of the electronic device in the thickness direction of the electronic device 100 or have a small interval, and a smaller interval is better. That is, a smaller interval indicates that heat generated by the second component module 6 and the second heat dissipation assembly 7 is more easily transferred to the housing of the electronic device and other components having a heat dissipation capability, and finally heat dissipation and temperature equalization of the electronic device are implemented through the housing and these components. In the thickness direction of the electronic device 100, an end that is of the second component module 6 and that is away from the rear cover 10 is connected to the second middle frame 2 through a thermally conductive medium 73. A space in the second accommodation cavity 23 in the thickness direction of the electronic device 100 is mostly reserved for the second component module 6 and the second heat dissipation assembly 7, to provide heat dissipation efficiency and facilitate a thin design of the electronic device.

In an implementation, the rotating shaft 3 is connected to the second heat dissipation assembly 7. For example, in a cross-section shown in FIG. 4, the second middle frame 2 is connected to the rotating shaft 3, and the second heat dissipation assembly 7 is indirectly connected to the rotating shaft 3 through the second middle frame 2. The second heat dissipation assembly 7 can conduct heat from the second component module 6 to the rotating shaft 3. In an implementation, both the second middle frame 2 and the rotating shaft 3 have heat-conducting properties. For example, materials of both the second middle frame 2 and the rotating shaft 3 include metal materials. For example, the second middle frame 2 may be made of aluminum alloy, and the rotating shaft 3 may include a metal material such as copper. In this solution, the rotating shaft 3 can participate in heat dissipation of the second component module 6, and the rotating shaft 3 may be considered as a part of the second heat dissipation assembly 7. This implementation helps improve heat dissipation efficiency of the electronic device 100.

In a possible implementation, a value range of a shortest distance between a heat generation center position of the second heat source 61 and an edge of the rotating shaft 3 is less than or equal to 5 cm. The heat generation center position of the second heat source 61 may be obtained through measurement. For example, the heat generation center position is located on a plane formed by the width direction (direction X) of the electronic device 100 and the thickness direction (direction Z) of the electronic device 100. The edge of the rotating shaft 3 has a perpendicular distance from the plane in the length direction of the electronic device 100. The perpendicular distance is approximately the shortest distance between the heat generation center position of the second heat source 61 and the edge of the rotating shaft 3. In this embodiment, the value range of the shortest distance between the edge of the rotating shaft 3 and the heat generation center position of the second heat source 61 in a specific implementation solution is constrained. The constraint indicating that the distance is less than or equal to 5 cm helps obtain good heat dissipation effect. This solution helps provide a short heat conduction path, namely, a heat transfer path of the second heat source 61, the second heat dissipation assembly 7, the second middle frame 2, and the rotating shaft 3, to improve heat transfer efficiency. The constraint indicating that the shortest distance between the heat generation center position and the edge of the rotating shaft 3 is less than or equal to 5 cm also helps implement structural compactness of components arranged in the second middle frame 2, to properly arrange a space in the electronic device 100.

In a possible implementation, the edge of the rotating shaft 3 is an edge that is adjacent to the second heat source 61 and that is of a door panel that is of the rotating shaft 3 and that corresponds to the second middle frame 2. The door panel of the rotating shaft 3 is a door panel that is of the rotating shaft 3 and that is adjacent to a side of the screen 101 of the electronic device 100. For example, in an electronic device 100, the rotating shaft 3 has two door panel structures: a left door panel and a right door panel. For example, one door panel (for example, the right door panel) is disposed opposite to the second middle frame 2. In this case, a value range of a shortest distance between an edge of the right door panel and the heat generation center position of the second heat source 61 is less than or equal to 5 cm. Optionally, the rotating shaft may alternatively have three door panels or another quantity of door panels.

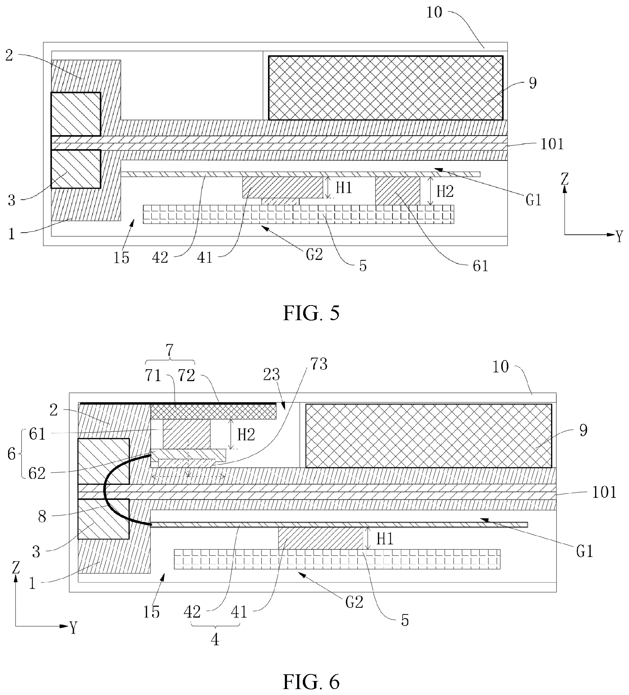

FIG. 5 is a diagram of a cross-sectional structure of an electronic device according to an embodiment of this application. With reference to FIG. 5, in an implementation, both the first heat source 41 and the second heat source 61 are disposed on the first middle frame 1. For example, both the first heat source 41 and the second heat source 61 are disposed on the first circuit board 42. The first heat dissipation assembly 5 performs active heat dissipation for the first heat source 41 and the second heat source 61. Because both heat from the second heat source 61 and heat from the first heat source 41 are concentrated in the first accommodation cavity 15, the first spacing G1 and the second spacing G2 still need to be kept in appropriate sizes. Because the maximum size H2 of the second heat source 61 in the third direction Z is greater than the maximum size H1 of the first heat source 41 in the third direction Z, a thickness size of a main body, of the electronic device, corresponding to the first middle frame 1 provided in the implementation shown in FIG. 5 needs to be greater than a thickness size of the main body, of the electronic device, corresponding to the first middle frame 1 provided in the implementation shown in FIG. 4. Therefore, compared with that in the implementation provided in FIG. 4, in the implementation shown in FIG. 5, a thickness difference between the main bodies of the electronic devices on the two sides of the rotating shaft 3 is larger.

Therefore, compared with that in the implementation shown in FIG. 5, in the implementation shown in FIG. 4, the second component module 6 with a large thickness is disposed on the second middle frame 2, so that an overall thickness of the main body, of the electronic device, in which the first middle frame 1 is located can be reduced. In the main body, of the electronic device, in which the first middle frame 1 is located, in the thickness direction, a size of the first component module 4 is close to a thickness of the first heat dissipation assembly 5. A size of the second component module 6 in the thickness direction is greater than the size of the first component module 4, and the size of the second component module 6 in the thickness direction is also greater than the thickness of the first heat dissipation assembly 5. Therefore, if the second component module 6 is disposed on the second middle frame, compared with a solution in which the second component module 6 is disposed on the first middle frame, a size, in the thickness direction, of the main body, of the electronic device, in which the first middle frame is located may be reduced. Therefore, in this embodiment of this application, a thickness difference between the main body, of the electronic device 100, in which the first middle frame 1 is located and a main body, of the electronic device 100, in which the second middle frame 2 is located can be reduced. In addition, the second component module 6 is disposed at a position between the battery 9 and the rotating shaft 3, and the second component module 6 and the rotating shaft 3 are disposed side by side, that is, do not overlap in the Z direction. This helps control a thickness of the main body, of the electronic device 100, in which the second middle frame 2 is located. In addition, the second component module 6 is adjacent to the rotating shaft 3, and the rotating shaft 3 may serve as a medium for passive heat dissipation of the second component module 6, that is, in this application, auxiliary heat dissipation may be performed through the rotating shaft 3. This helps improve heat dissipation efficiency.

For example, in this embodiment of this application, the first component module 4 having high load and a low thickness uses active heat dissipation, and is arranged in a space, of the electronic device, in which the first middle frame 1 located on one side of the rotating shaft 3 is located, and active heat dissipation is performed for the first component module 4 through the first heat dissipation assembly 5 including core heat dissipation modules such as the vapor chamber 51 and the fan 52. The second component module 6 having low load and a high thickness uses passive heat dissipation, and is arranged in a space, of the electronic device, in which the second middle frame 2 located on the other side of the rotating shaft 3 is located, and passive heat dissipation is performed for the second component module 6 through the second heat dissipation assembly 7. In this embodiment of this application, the first component module and the second component module are respectively disposed in two different main bodies, to avoid concentration of components with a large thickness size in a same main body, reduce a thickness difference between the two main bodies, achieve advantages of being aesthetically pleasing, light, and thin, and improve performance of the first component module and the second component module.

In the implementation shown in FIG. 4, passive heat dissipation performed for the second component module 6 through the second heat dissipation assembly 7 is described. Based on the implementation shown in FIG. 4, an embodiment shown in FIG. 6 provides a specific design of the second heat dissipation assembly 7. A difference between the implementation shown in FIG. 6 and the implementation shown in FIG. 4 lies in a specific structure of the second heat dissipation assembly 7.

FIG. 6 is another diagram of a cross-sectional structure of an electronic device according to an embodiment of this application. With reference to FIG. 6, in a possible implementation, the second heat dissipation assembly 7 includes a heat dissipation plate 71 and a thermally conductive structure 72. The heat dissipation plate 71 is stacked on a side that is of the second heat source 61 and that faces away from the second circuit board 62, and the thermally conductive structure 72 is located on a side that is of the heat dissipation plate 71 and that faces away from the second heat source 61. That is, the second circuit board 62, the second heat source 61, the heat dissipation plate 71, and the thermally conductive structure 72 are sequentially disposed in a stacked manner in the third direction Z. The heat dissipation plate 71 may alternatively be a heat dissipation stand. In an implementation, the heat dissipation plate 71 has temperature equalization performance. In an implementation, the heat dissipation plate 71 may be a metal plate or a heat sink structure with a heat dissipation fin. Alternatively, the heat dissipation plate 71 may be a heat dissipation structure of another type such as a vapor chamber or a combination of a metal plate and a heat pipe. Optionally, the heat dissipation plate 71 is plate-shaped. In the third direction Z (the thickness direction of the electronic device 100), the heat dissipation plate 71 is located between the rear cover 10 and the second component module 6. In the second direction Y (the length direction of the electronic device 100), the heat dissipation plate 71 is located between the battery 9 and a part of the second middle frame 2. In an implementation, the heat dissipation plate 71 may be attached to or thermally connected to a side that is of the second heat source 61 and that faces away from the screen 101 (for example, connected through a thermally conductive medium). The heat dissipation plate 71 can conduct heat from the second heat source 61 to another element in the electronic device 100, for example, the second middle frame 2, the rotating shaft 3, or the rear cover 10.

In an implementation, the heat dissipation plate 71 may be fastened to the circuit board, and is fastened to the second middle frame 2 through a fastener, for example, a screw. For example, by fastening the heat dissipation plate 71 and the second middle frame 2, a position of the second circuit board 62 on which the second heat source 61 is located can be fastened. The heat dissipation plate 71 and the second heat source 61 are connected through a thermally conductive medium, so that there is no high thermal resistance between the second heat source 61 and the heat dissipation plate 71 (for example, air, where if no thermally conductive medium is disposed, there is air at a position at which the second heat source 61 and the heat dissipation plate 71 cannot be completely attached, and thermal resistance of the air is high, which affects heat dissipation).

With reference to FIG. 6, in a possible implementation, the thermally conductive structure 72 is sheet-shaped. Optionally, the thermally conductive structure 72 is a graphite sheet, and has a nanometer-level thickness. In the third direction Z (the thickness direction of the electronic device 100), the thermally conductive structure 72 may be disposed on a side that is of the heat dissipation plate 71 and that faces away from the second heat source 61. In an implementation, a part of the thermally conductive structure 72 is connected to the heat dissipation plate 71, and another part of the thermally conductive structure 72 is connected to the second middle frame 2. The thermally conductive structure 72 can improve heat conduction between the heat dissipation plate 71 and the second middle frame 2. In the third direction Z (the thickness direction of the electronic device 100), a part of the second middle frame 2 and the rotating shaft 3 are disposed in a stacked manner. Because the thermally conductive structure 72 is connected to the second middle frame 2, the heat from the second heat source 61 may be transferred to the second middle frame 2 and the rotating shaft 3 through the thermally conductive structure 72. This helps improve heat dissipation efficiency of the electronic device 100. In an implementation, the thermally conductive structure 72 is attached to an inner surface of the rear cover 10. To avoid concentrated overheating at a position that is of the rear cover 10 and that directly faces the heat source, in this solution, the thermally conductive structure 72 is used to distribute heat. Therefore, the thermally conductive structure 72 can implement temperature equalization of the electronic device.

The thermally conductive structure 72 provided in this solution can guide the heat from the second heat source 61 to another element in the electronic device 100, for example, the second middle frame 2, the rotating shaft 3, or the rear cover 10, on the basis of the heat dissipation plate 71, to implement efficient heat dissipation without additionally occupying a Z-direction space of the electronic device 100 on a side of the second middle frame 2, thereby helping implement a light and thin high-performance electronic device 100. In another implementation, the thermally conductive structure 72 may alternatively be a structure that has a heat-conducting property and that is made of another material, for example, a thermally conductive pad, a vapor chamber, or a heat pipe. An appropriate thermally conductive structure may be selected based on a space requirement in the electronic device, to implement stacking in the thickness direction.

With reference to FIG. 6, in a possible implementation, the second circuit board 62 and the second middle frame 2 are connected through a thermally conductive medium 73, and the screen 101 of the electronic device 100 is on a side that is of the second middle frame 2 and that faces away from the second circuit board 62. The screen 101, the second middle frame 2, the thermally conductive medium 73, the second circuit board 62, the second heat source 61, the heat dissipation plate 71, the thermally conductive structure 72, and the rear cover 10 are sequentially disposed in a stacked manner in the third direction Z (the thickness direction of the electronic device 100). In this embodiment, through the foregoing layout, a first heat transfer path of the second heat source 61, the heat dissipation plate 71, the thermally conductive structure 72, the second middle frame 2, and the rotating shaft 3 and a second heat transfer path of the second heat source 61, the second circuit board 62, the thermally conductive medium 73, and the second middle frame 2 can be formed, so that the rotating shaft 3 and the second middle frame 2 can participate in work of the second heat dissipation assembly 7, thereby improving heat dissipation efficiency. It should be noted that the middle frame receives heat from the heat source. Because the middle frame is of a large-area structure, the heat may be distributed through the middle frame, to avoid local overheating of the screen 101 caused because the heat is concentrated at a specific position. The middle frame distributes the heat to achieve temperature equalization effect. In this way, heat on the screen 101 can be controlled within an appropriate range, to meet a use requirement of the screen 101. In a specific implementation, there is a small gap between the middle frame and the screen 101, and thermal isolation between the middle frame and the screen 101 is implemented through the gap. Thermal isolation may alternatively be implemented between the screen 101 and the middle frame by attaching heat insulation foam.

Based on the implementation shown in FIG. 6, in this embodiment of this application, more details may be designed for the second heat dissipation assembly 7, to optimize passive heat dissipation efficiency of the second component module 6. For example, in this embodiment of this application, the structure of the second heat dissipation assembly 7 in FIG. 6 can be further refined to optimize a heat transfer path between the second heat dissipation assembly 7 and another component in the electronic device, so as to improve heat dissipation efficiency.

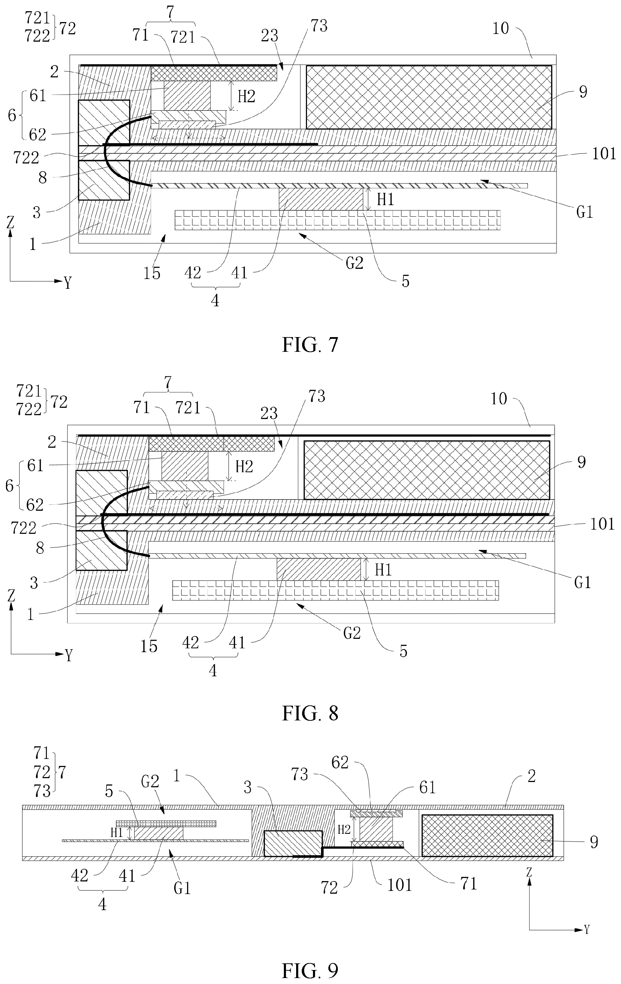

FIG. 7 is another diagram of a cross-sectional structure of an electronic device according to an embodiment of this application. With reference to FIG. 7, a difference between the implementation shown in FIG. 7 and the implementation shown in FIG. 6 lies in that in a possible implementation, the thermally conductive structure 72 includes a first thermally conductive portion 721 and a second thermally conductive portion 722. The first thermally conductive portion 721 is disposed between the heat dissipation plate 71 and the rear cover 10. The first thermally conductive portion 721 may be disposed on an inner side of the rear cover 10, or may be disposed on the heat dissipation plate 71. The second thermally conductive portion 722 is disposed between the second middle frame 2 and the screen 101, that is, the second thermally conductive portion 722 is disposed on a side that is of the second middle frame 2 and that faces away from the thermally conductive medium 73. The second thermally conductive portion 722 is disposed between the second middle frame 2 and the screen 101 in a stacked manner. The second thermally conductive portion 722 disposed on the side that is of the second middle frame 2 and that faces away from the thermally conductive medium 73 extends in the second direction Y (the length direction of the electronic device 100) to overlap a part of the rotating shaft 3. In this implementation, the second thermally conductive portion 722 is disposed between the rotating shaft 3 and the screen 101, and the first thermally conductive portion 721 is disposed between the rotating shaft 3 and the rear cover 10, so that the rotating shaft 3 can participate in heat dissipation of the second component module 6 through a connection between the second middle frame 2 and the rotating shaft 3. In this solution, a first heat transfer path of the second heat source 61, the heat dissipation plate 71, the first thermally conductive portion 721, the second middle frame 2, and the rotating shaft 3 and a second heat transfer path of the second heat source 61, the second circuit board 62, the thermally conductive medium 73, the second middle frame 2, the second thermally conductive portion 722, and the rotating shaft 3 can be formed. It may be learned from the foregoing heat transfer path that compared with the electronic device 100 shown in FIG. 6, in this embodiment, the second thermally conductive portion 722 is added to enhance heat transfer efficiency.

In an implementation, the thermally conductive structure 72 may be a graphite sheet, and has a small thickness. This helps improve heat dissipation efficiency in a limited space of the electronic device. In this solution, a solution of disposing the thermally conductive structure 72 on both two opposite sides of the second heat source 61 in the thickness direction can more effectively conduct heat from the second heat source 61 to the rotating shaft 3, to improve utilization of participation by the rotating shaft in heat dissipation. In this implementation, a part of the thermally conductive structure 72 is laid between the second middle frame 2 and the screen 101, to optimize a transfer path between the heat generated by the second heat source 61 and an external environment, thereby helping improve heat dissipation efficiency of the electronic device 100.

Based on the implementation shown in FIG. 7, in this embodiment of this application, more details may be further designed for the thermally conductive structure 72 of the second heat dissipation assembly 7, to optimize passive heat dissipation efficiency of the second component module 6.

FIG. 8 is another diagram of a cross-sectional structure of an electronic device according to an embodiment of this application. A difference between the implementation shown in FIG. 8 and the implementation shown in FIG. 7 lies in that a part of the thermally conductive structure 72 is on an inner surface of the rear cover and extends to be separately stacked with the second middle frame and the battery, and a part of the thermally conductive structure 72 is between the second middle frame 2 and the screen 101 and extends to be separately stacked with the rotating shaft and the battery. With reference to FIG. 8, in a possible implementation, the thermally conductive structure 72 includes a first thermally conductive portion 721 and a second thermally conductive portion 722. The first thermally conductive portion 721 extends in the second direction Y (the length direction of the electronic device) to be disposed in a stacked manner with the battery 9. The screen 101, the second middle frame 2, the battery 9, and the first thermally conductive portion 721 are disposed in a stacked manner in the third direction Z (the thickness direction of the electronic device). In this solution, a first heat transfer path of the second heat source 61, the heat dissipation plate 71, the first thermally conductive portion 721, and the rotating shaft 3 and a second heat transfer path of the battery 9, the first thermally conductive portion 721, and the rear cover 10 can be formed. In this embodiment, the second thermally conductive portion 722 is located between the screen 101 and a part that is of the second middle frame 2 and that is adjacent to the battery 9, that is, in the thickness direction (the Z direction shown in the figure) of the electronic device 100, the screen 101, the second thermally conductive portion 722, the second middle frame 2, the battery 9, and a part of the thermally conductive structure 72 are disposed in a stacked manner, that is, there is a part of the thermally conductive structure 72 on each of two sides of the battery 9 in the thickness direction of the electronic device 100. In this solution, a third heat transfer path of the battery 9, the second middle frame 2, and the second thermally conductive portion 722 can be formed. In this solution, through the three heat transfer paths that can be formed, inherent elements of the electronic device 100, for example, the rotating shaft 3, the rear cover 10, and the second middle frame 2, can be effectively used to transfer heat generated by the second component module 6 and the battery 9, that is, the rotating shaft 3, the rear cover 10, and the second middle frame 2 can participate in heat dissipation of the second component module 6. This provides heat dissipation for the battery 9, and improves heat dissipation efficiency of the electronic device 100.

With reference to FIG. 8, a part of the second thermally conductive portion 722 extends between the screen 101 and a part that is of the second middle frame 2 and that corresponds to the battery 9. Another part of the second thermally conductive portion 722, a part of the second middle frame 2, the second component module 6, and the second heat dissipation assembly 7 are sequentially disposed in a stacked manner in the thickness direction (the Z direction shown in the figure) of the electronic device 100. In addition, the second thermally conductive portion 722, the rotating shaft 3, a part of the second middle frame 2, and the first thermally conductive portion 721 are sequentially disposed in a stacked manner in the thickness direction (the Z direction shown in the figure) of the electronic device 100. In the thickness direction of the electronic device 100, there is a part of the thermally conductive structure 72 on each of two sides of the second heat source 61, that is, the first thermally conductive portion 721 and the second thermally conductive portion 722 are respectively disposed. In addition, there is a part of the thermally conductive structure 72 on each of two sides of the battery 9, that is, the first thermally conductive portion 721 and the second thermally conductive portion 722 are respectively disposed. In this solution, the first thermally conductive portion 721 with a large area is disposed on the inner surface of the rear cover 10, and the second thermally conductive portion 722 with a large area is disposed at a position between the second middle frame 2 and the screen 101, so that lightness and thinness of the electronic device 100 can be ensured, and heat dissipation efficiency of the electronic device 100 can be improved.

Based on the implementation shown in FIG. 8, the first thermally conductive portion 721 may cover only regions in which the heat dissipation plate 71 and the battery 9 are located, that is, the first thermally conductive portion 721 may be disposed to avoid a position of the rotating shaft 3, so as to save a space in a region in which the rotating shaft is located. The second thermally conductive portion 722 may also cover only a region other than the rotating shaft 3 on the second middle frame 2, that is, the second thermally conductive portion 722 may also avoid the position of the rotating shaft 3, to save a space in the region in which the rotating shaft is located. On the two sides of the battery 9 in the third direction Z, each of the first thermally conductive portion 721 and the second thermally conductive portion 722 may cover a part or all of a region of the battery 9. Therefore, specific disposition of the thermally conductive structure 72 is not constrained in this application. The thermally conductive structure 72 may be properly arranged based on a requirement of a specific application scenario.

In the implementations shown in FIG. 6, FIG. 7, and FIG. 8, refinement of the structure of the second heat dissipation assembly 7 is described, to optimize passive heat dissipation efficiency of the second component module 6. On this basis, in this embodiment of this application, a position of the middle frame in FIG. 6, FIG. 7, and FIG. 8 can be further improved, to ensure passive heat dissipation efficiency of the second component module 6, and implement lightness and thinness of the electronic device 100.

FIG. 9 is a diagram of a cross-sectional structure of an electronic device in a flattened state according to an embodiment of this application. With reference to FIG. 9, a difference between the implementation shown in FIG. 9 and the implementations shown in FIG. 6, FIG. 7, and FIG. 8 lies in that the middle frame is disposed in a different manner. In a possible implementation, the first middle frame 1 and the second middle frame 2 may be used to replace a position and a function of the rear cover. That is, the first middle frame 1 and the second middle frame 2 of the electronic device 100 are located at the position of the rear cover and serve as the rear cover, each of the first middle frame 1 and the second middle frame 2 is disposed at an interval from a part of the screen 101 to form an accommodation space, and functional components in the electronic device are disposed in the accommodation space. In the third direction Z (the thickness direction of the electronic device 100), the first middle frame 1 is disposed on a side that is of the first component module 4 and that faces away from the screen 101, and the screen 101, the first component module 4, the first heat dissipation assembly 5, and the first middle frame 1 can be sequentially disposed in a stacked manner. The screen 101 is disposed on a side that is of the heat dissipation plate 71 and that faces away from the second circuit board 62, the second middle frame 2 is disposed on a side that is of the second component module 6 and that faces away from the screen 101, and the screen 101, the thermally conductive structure 72, the heat dissipation plate 71, the second heat source 61, the second circuit board 62, the thermally conductive medium 73, and the second middle frame 2 can be sequentially disposed in a stacked manner.

With reference to FIG. 9, in an implementation, the second circuit board 62 and the second middle frame 2 can be connected through a thermally conductive medium 73, to implement a first heat transfer path of the second heat source 61, the second circuit board 62, the thermally conductive medium 73, and the second middle frame 2. The heat dissipation plate 71 is located between the second circuit board 62 and the screen 101. A part of the thermally conductive structure 72 can be attached to the heat dissipation plate 71, that is, a part of the thermally conductive structure 72 is located between the heat dissipation plate 71 and the screen 101. A part of the thermally conductive structure 72 can extend in the second direction Y (the length direction of the electronic device 100) to be attached to the rotating shaft 3, that is, a part of the thermally conductive structure 72 is located between the rotating shaft 3 and the screen 101. This can implement a second heat transfer path of the second heat source 61, the heat dissipation plate 71, the thermally conductive structure 72, and the rotating shaft 3 and a third heat transfer path of the second heat source 61, the heat dissipation plate 71, the thermally conductive structure 72, and the screen 101. In this embodiment, the first middle frame 1 and the second middle frame 2 are disposed at the position of the rear cover of the electronic device, to replace the rear cover. This eliminates a space occupied by the rear cover in the thickness direction of the electronic device 100, can transfer, through an inherent element of the electronic device 100, heat generated by the second component module 6, and finally ensures passive heat dissipation efficiency of the second component module 6, and implements lightness and thinness of the electronic device 100.

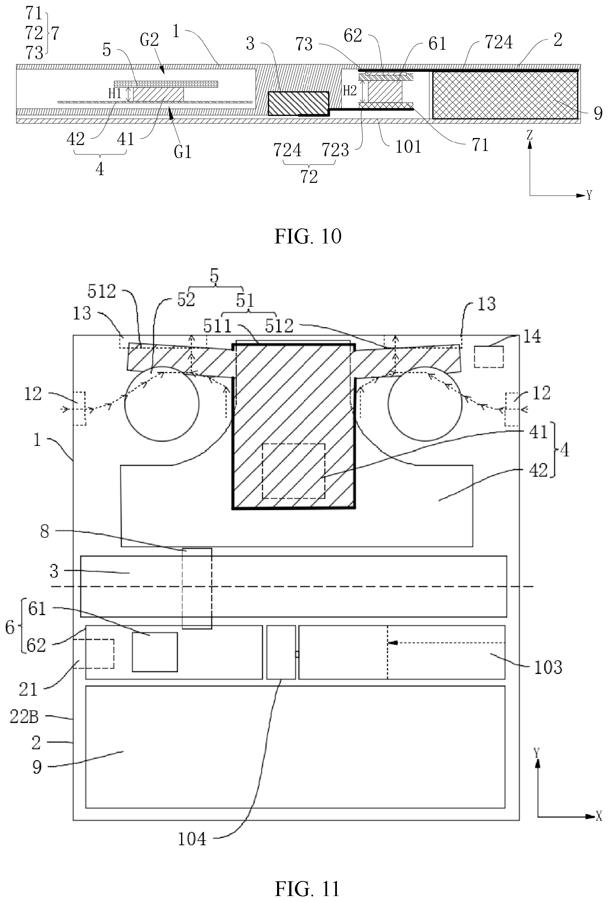

In the implementation shown in FIG. 9, positions of the first middle frame 1 and the second middle frame 2 are designed, to ensure passive heat dissipation efficiency of the second component module 6, and implement lightness and thinness of the electronic device 100. In an embodiment shown in FIG. 10 in this application, a specific configuration of the thermally conductive structure 72 can be further refined to optimize a heat transfer path between the second heat dissipation assembly 7 and another component in the electronic device 100, so as to improve heat dissipation efficiency.

FIG. 10 is another diagram of a cross-sectional structure of an electronic device in a flattened state according to an embodiment of this application. With reference to FIG. 10, a difference between this solution and the implementation shown in FIG. 9 lies in details of the thermally conductive structure 72. In a possible implementation, the thermally conductive structure 72 of the electronic device 100 in this embodiment includes a third thermally conductive portion 723 and a fourth thermally conductive portion 724. In the third direction Z (the thickness direction of the electronic device 100), the fourth thermally conductive portion 724 is located between the second middle frame 2 and the second circuit board 62, and the second circuit board 62, the thermally conductive medium 73, the fourth thermally conductive portion 724, and the second middle frame 2 can be sequentially disposed in a stacked manner. This may form a third heat transfer path of the second heat source 61, the second circuit board 62, the thermally conductive medium 73, the fourth thermally conductive portion 724, and the second middle frame 2. In an implementation, the fourth thermally conductive portion 724 can extend in the length direction of the electronic device 100 to a battery compartment region in which the battery 9 is located, that is, the fourth thermally conductive portion 724 and the battery 9 are disposed in a stacked manner in the thickness direction of the electronic device 100, that is, there is the fourth thermally conductive portion 724 between the battery 9 and the second middle frame 2. This may form a fourth heat transfer path of the battery 9, the fourth thermally conductive portion 724, and the second middle frame 2. In this embodiment, the fourth thermally conductive portion 724 is laid between the battery 9 and the second middle frame 2. Compared with the electronic device 100 shown in FIG. 9, two additional heat transfer paths are obtained in this solution. In this embodiment, lightness and thinness of the electronic device 100 are ensured, and passive heat dissipation efficiency of the second heat source 61 can be improved. In addition, the four heat transfer paths enable the rotating shaft 3 and the second middle frame 2 to participate in heat dissipation of the second component module 6 and the battery 9, thereby expanding heat dissipation areas of the second component module 6 and the battery 9, and helping improve heat dissipation efficiency of the electronic device 100.

In the implementation shown in FIG. 3, a region between the rotating shaft 3 and the battery 9 is used to arrange the second component module 6 and the second heat dissipation assembly 7. The second circuit board 62 may be in a long strip shape and extend in the first direction X (a direction parallel to the rotating shaft), and the second heat source 61 may be disposed at any position on the second circuit board 62. In this embodiment of this application, a built-in stand may be further disposed in the electronic device, so that when the electronic device is in the flattened state, the electronic device can be supported through the built-in stand, which is convenient for use and improves use comfort and experience. For a specific design, refer to an implementation shown in FIG. 11.

FIG. 11 is another diagram of a top-view structure of an electronic device that is in a flattened state and that is not provided with a rear cover according to an embodiment of this application. A difference between this solution and the implementation shown in FIG. 3 lies in that disposition of a stand 103 and a design of integrating a charging circuit corresponding to the second charging interface 21 into the second circuit board 62 are added. With reference to FIG. 11, in a possible implementation, the second charging interface 21 is disposed on the fourth side edge 22B of the second middle frame 2. The second circuit board 62 of the second component module 6 is adjacent to the fourth side edge 22B. The second heat source 61 is disposed on the second circuit board 62 in the thickness direction of the electronic device 100. The second circuit board 62 further includes a charging circuit and a connector. Both the charging circuit and the connector are configured to be electrically connected to the second charging interface 21, that is, the second charging interface 21 is electrically connected to the second circuit board 62. In this embodiment, the second heat source 61 and the second circuit board 62 of the second component module 6, and the second charging interface 21 of the electronic device 100 are electrically connected, and the second heat source 61, the second circuit board 62, and the second charging interface 21 are integrated, to save a space in the second accommodation cavity 23 of the electronic device 100. The electronic device 100 further includes the stand 103 and a stand rotating shaft 104. The stand 103 is connected to the stand rotating shaft 104, so that the stand 103 is capable of flipping around the stand rotating shaft 104. The stand 103 and the stand rotating shaft 104 are located between the battery 9 and the rotating shaft 3, and the second component module 6 and the stand 103 are distributed on two sides of the stand rotating shaft 104.

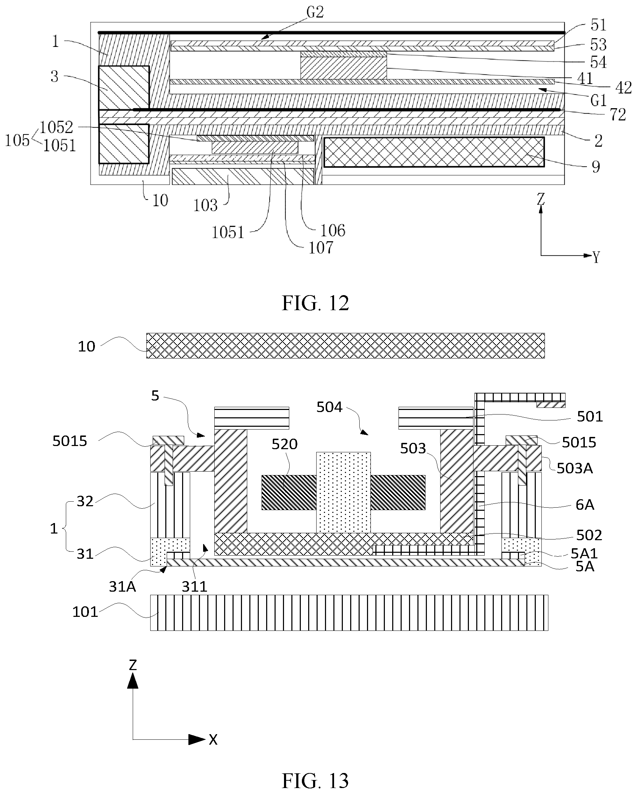

FIG. 12 is a diagram of a cross-sectional structure of the electronic device shown in FIG. 11 in a folded state. With reference to FIG. 11 and FIG. 12, the stand 103 and the battery 9 and the stand rotating shaft 104 and the battery 9 are disposed in a staggered manner in the second direction Y (the length direction of the electronic device 100), that is, in the third direction Z (the thickness direction of the electronic device 100), the stand 103 and the stand rotating shaft 104 do not occupy a Z-direction space of the battery 9, which helps reduce a Z-direction space size of the electronic device 100 on a side of the second middle frame 2. A window is disposed on the rear cover 10, and the window is used to accommodate the stand 103. When the stand 103 is not used, the stand 103 is completely closed. In this case, in the first direction X (the width direction of the electronic device 100), the stand 103 and a part that is of the rear cover 10 and that is close to the second middle frame 2 can be on a same plane. The electronic device 100 in the unfolded state shown in FIG. 11 is used as an example. When the stand 103 needs to be used, the stand 103 flips around the stand rotating shaft 104 to open. In this case, the stand 103 can form a specific included angle with a plane formed by the first direction X and the second direction Y. For example, a projection of an end that is of the stand 103 in the open state and that is away from the stand rotating shaft 104 in the thickness direction of the electronic device 100 may be a dashed line position to which a dashed line arrow in FIG. 11 points.

With reference to FIG. 11 and FIG. 12, in a possible implementation, the rotating shaft 3 and the stand rotating shaft 104 can form a "T-shaped" layout shown in FIG. 11 and enclose the second heat source 61 of the electronic device 100. Specifically, the second component module 6 and the stand 103 can be distributed on the two sides of the stand rotating shaft 104. That is, the stand rotating shaft 104 can divide the second accommodation cavity 23 into two accommodation sub-cavities, the second component module 6 and the second heat dissipation assembly 7 are located in one of the accommodation sub-cavities, and the stand 103 can be disposed in a stacked manner with the other accommodation sub-cavity in the third direction Z (the thickness direction of the electronic device 100). In this way, the stand 103 is disposed in a staggered manner from both the second component module 6 and the second heat dissipation assembly 7 in the width direction of the electronic device 100, namely, the first direction, that is, in the length direction of the electronic device 100, the stand 103 and the stand rotating shaft 104 do not occupy an additional Y-direction space of the electronic device 100 on the side of the second middle frame 2, which helps implement high integration and miniaturization of the electronic device 100. In an implementation, the second heat dissipation assembly 7 is configured to conduct heat from the second heat source 61 to the stand rotating shaft 104. Because the second heat dissipation assembly 7 is disposed on the second middle frame 2, and the second middle frame 2 is connected to the rotating shaft 3 and the stand rotating shaft 104, heat generated by the second heat source 61 of the second component module 6 can be sequentially transferred to the rotating shaft 3 and the stand rotating shaft 104 along the second heat dissipation assembly 7 and the second middle frame 2. The stand rotating shaft 104 can participate in heat dissipation of the second component module 6, thereby expanding a heat dissipation area of the second component module 6, and helping improve heat dissipation efficiency of the electronic device 100. In an implementation, each of the second middle frame 2, the rotating shaft 3, and the stand rotating shaft 104 includes a metal material or another material having a good heat-conducting property, and each of the second middle frame 2, the rotating shaft 3, and the stand rotating shaft 104 has a good heat-conducting property. In this embodiment, the second heat dissipation assembly 7 conducts heat from the second component module 6 to the stand rotating shaft 104, so that effective passive heat dissipation can be implemented for the second component module 6 with a large thickness through an inherent element of the electronic device 100, and no additional element for performing active heat dissipation, for example, a fan and a liquid cooling element, needs to be disposed for cooperation, which helps reduce a thickness of the electronic device 100.

With reference to FIG. 11 and FIG. 12, in a possible implementation, the electronic device 100 further includes a third component module 105. In an implementation, the third component module 105 is a third-type component (a component that has low load and whose size is a low height). The third component module 105 is located between the battery 9 and the rotating shaft 3, that is, the battery 9, the third component module 105, and the rotating shaft 3 are sequentially arranged in the second direction Y (the length direction of the electronic device 100). The third component module 105 and the second component module 6 are sequentially arranged in the first direction X (the width direction of the electronic device 100). The third component module 105 and the stand 103 are disposed in a stacked manner in the third direction Z (the thickness direction of the electronic device 100). A maximum size of the third component module 105 in the thickness direction of the electronic device 100 is less than a maximum size of the first component module 4 in the thickness direction of the electronic device 100. Optionally, the third component module 105 may include a low-load component such as a resistor, a capacitor, and an inductor. In this embodiment, the third component module 105 is disposed in a space that overlaps the stand 103 in the thickness direction of the electronic device 100. The third component module 105 has a small thickness, and therefore jointly occupies a thickness space of a region with the stand 103. This helps save the internal space of the electronic device 100, to implement lightness and thinness of the electronic device 100. In addition, the third component module 105 and the stand 103 are disposed in a stacked manner, the stand 103 is connected to the stand rotating shaft 104, and the stand rotating shaft 104 is connected to the second middle frame 2, so that heat generated by a functional component in the third component module 105 can also be effectively dissipated through the stand 103, the stand rotating shaft 104, and the rotating shaft 3. In this way, the stand 103, the stand rotating shaft 104, and the rotating shaft 3 participate in heat dissipation of the third component module 105, thereby expanding a heat dissipation area of the third component module 105, and helping improve heat dissipation efficiency of the electronic device 100. For example, compared with the first component module 4 and the second component module 6, the third component module 105 has lowest load and a smallest thickness. The third component module 105 is arranged below the stand 103 in the thickness direction of the electronic device 100, and the stand 103 does not overlap the battery 9, so that a space of the battery 9 can be not affected, and no additional heat dissipation element needs to be added to dissipate heat for the third component module 105, which helps implement lightness and thinness of the electronic device 100.

With reference to FIG. 11 and FIG. 12, in a possible implementation, the third component module 105 includes an electronic component 1051 and a third circuit board 1052. The electronic component 1051 is disposed on the third circuit board 1052, and the third circuit board 1052 can be connected to the second middle frame 2. Optionally, the electronic device 100 further includes a support structure 106 and a shielding structure 107. In the third direction Z (the thickness direction of the electronic device 100), the support structure 106, the shielding structure 107, and a part that is of the rear cover 10 and that is close to the second middle frame 2 can be sequentially disposed, and the support structure 106, the shielding structure 107, and the stand 103 can also be sequentially disposed. The shielding structure 107 may be a metal sheet, and the shielding structure 107 is configured to shield the support structure 106 and may serve as a decorative member. The screen 101, the second middle frame 2, the third circuit board 1052, the electronic component 1051, the support structure 106, and the stand 103 are sequentially disposed in a stacked manner in the thickness direction (the Z direction shown in the figure) of the electronic device 100, that is, the support structure 106 is disposed between the electronic component 1051 and the stand 103. The support structure 106 can be configured to protect the third component module 105. The electronic component 1051 in the third component module 105 is located between the support structure 106 and the third circuit board 1052, and the third component module 105 and the electronic component 1051 are shielded and protected through the support structure 106, so that in the flipping process of the stand 103, the electronic component 1051 in the third component module 105 is not exposed.

The support structure 106, the shielding structure 107, and the stand 103 can be sequentially disposed in a stacked manner in the thickness direction of the electronic device 100, that is, the support structure 106 and the shielding structure 107 are disposed between the electronic component 1051 and the stand 103. The shielding structure 107 can be configured to make an exposed part of the support structure 106 aesthetically pleasing in the flipping process of the stand 103, and can enhance isolation between the third component module 105 and the outside.

With reference to FIG. 12, in a possible implementation, the support structure 106 is in a flat plate shape. In a possible implementation, the support structure 106 may be of a step-shaped structure, and the support structure 106 of the step-shaped structure may cover structural members of different sizes. For example, the third component module 105 has different heights, or a related structure of the rotating shaft or a second middle frame adjacent to the third component module 105 has different sizes. The shielding structure 107 and the stand 103 may also be step-shaped, to adapt to the step-shaped multi-component structure. The step-shaped support structure 106, the shielding structure 107, and the stand 103 can not only fully fill a height difference caused by electronic components 1051 of different sizes, but also do not additionally occupy an additional space of the second middle frame 2 in the thickness direction of the electronic device 100. The step-shaped stand 103 can further have stronger support strength, thereby facilitating stability when the electronic device 100 is placed in any available placement region through the stand 103, and finally implementing efficient running of the electronic device 100.

In an implementation, the stand 103 includes a metal material. A magnetic structure is disposed on the support structure 106. Through a magnetic attraction force between the magnetic structure and the stand 103, a position of the stand 103 can be fastened when the stand 103 is in a closed state, to prevent the stand 103 from freely flipping.

With reference to FIG. 11 and FIG. 12, in a possible implementation, the first heat dissipation assembly 5 can include a vapor chamber 51, a fan 52, a cooling plate 53, and a thermally conductive pad 54. The screen 101, the first middle frame 1, the first circuit board 42, the first heat source 41, the thermally conductive pad 54, the cooling plate 53, the vapor chamber 51, and the rear cover 10 can be sequentially disposed in a stacked manner in the thickness direction (the Z direction shown in the figure) of the electronic device 100. That is, in the thickness direction of the electronic device 100, the first heat source 41 is located between the first circuit board 42 and the vapor chamber 51, and the first middle frame 1 is connected to the screen 101 of the electronic device 100. There are at least two fans 52, and the at least two fans 52 may be respectively disposed on two opposite sides of the vapor chamber 51 in the width direction (the direction X shown in the figure) of the electronic device 100. Optionally, two support members can be disposed on the two opposite sides of the vapor chamber 51 in the width direction of the electronic device 100. The at least two fans 52 may be connected to the two support members. The fan 52 and the vapor chamber 51 jointly implement active heat dissipation. The cooling plate 53 and the thermally conductive pad 54 are configured to improve heat dissipation efficiency on a heat dissipation path for active heat dissipation. In an implementation, the cooling plate 53 may be made of copper. The thermally conductive pad 54 may be thermally conductive gel or another type of thermally conductive medium.

In the implementation shown in FIG. 12, a detailed architecture of the first heat dissipation assembly 5, for example, the solution of disposing the cooling plate 53 and the thermally conductive pad 54 in the first heat dissipation assembly 5, may also be used in any one of the possible implementation solutions shown in FIG. 4 to FIG. 10.

The solutions of disposing the stand 103 in the electronic device shown in FIG. 11 and FIG. 12 may also be used in any one of the possible implementation solutions shown in FIG. 4 to FIG. 10.

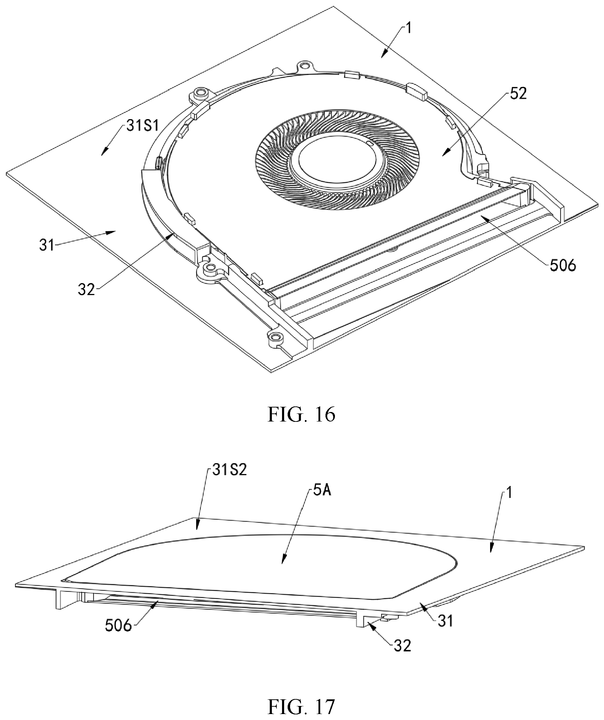

In an implementation, the first heat dissipation assembly provided in this application is mounted on the first middle frame. For example, a bottom of the first heat dissipation assembly may directly lap with a bottom wall of the first middle frame. However, this structure has a problem of a large thickness, and is not conducive to an overall thin design of the electronic device. Therefore, this application provides a specific implementation. A through hole is disposed on the first middle frame, and the through hole is used to accommodate the first heat dissipation assembly, which facilitates an overall thin design of the electronic device. In an implementation of this application, a connection structure between the fan and the middle frame and a specific air exhaust structure are described, and specific descriptions are provided in specific implementations shown in FIG. 13, FIG. 14, and FIG. 15. In subsequent implementation examples, a related connection structure between the fan and the middle frame and a specific air exhaust structure are described in other specific embodiments (for example, specific implementations shown in FIG. 16 to FIG. 21).

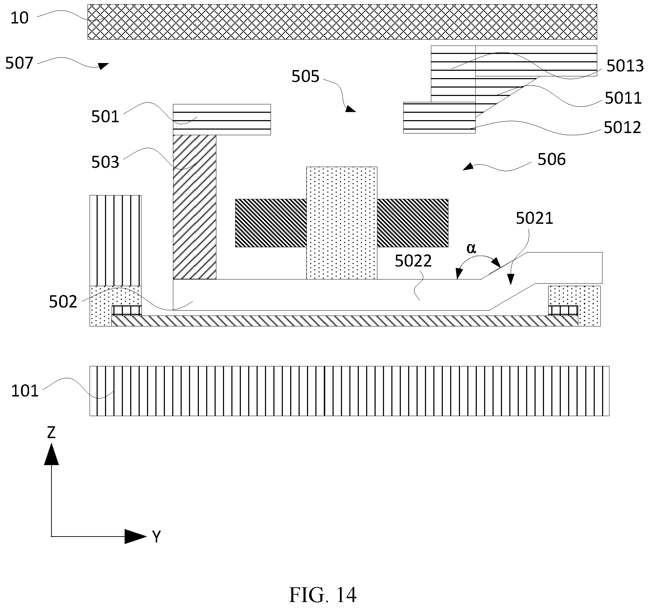

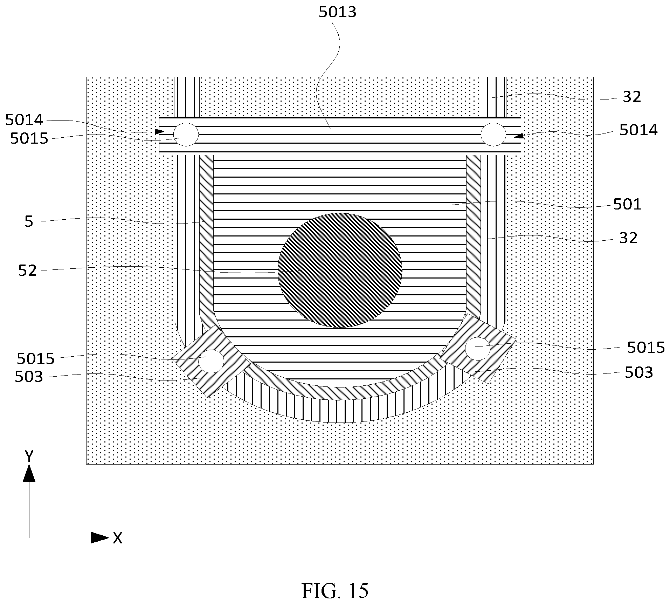

FIG. 13 is a cross-sectional view of an electronic device according to an implementation of this application. FIG. 13 shows a connection structure on a cross section between a first heat dissipation assembly and a first middle frame. A horizontal direction of the cross-sectional view shown in FIG. 13 is a first direction X (namely, an axial direction of a rotating shaft of the electronic device), and a vertical direction of the cross-sectional view shown in FIG. 13 is a third direction Z (namely, a thickness direction of the electronic device). FIG. 14 is a cross-sectional view of the electronic device in FIG. 13 from another perspective. FIG. 14 shows a specific structure of a fan housing and positions of an air intake vent and an air exhaust vent. A horizontal direction of the cross-sectional view shown in FIG. 14 is a second direction Y (namely, a length direction of the electronic device, where the second direction is perpendicular to the first direction X), and a vertical direction of the cross-sectional view shown in FIG. 14 is the third direction Z (namely, the thickness direction of the electronic device). FIG. 15 is a top view of an internal structure of the electronic device in FIG. 13. FIG. 15 shows a connection structure between the fan housing and the middle frame. A horizontal direction of the cross-sectional view shown in FIG. 15 is the first direction X (namely, the axial direction of the rotating shaft of the electronic device), and a vertical direction of the cross-sectional view shown in FIG. 15 is the second direction Y (namely, the length direction of the electronic device).

As shown in FIG. 13, the electronic device includes a rear cover 10, a screen 101, a first middle frame 1, and a first heat dissipation assembly 5. The first middle frame 1 is disposed between the rear cover 10 and the screen 101 in a stacked manner, and the first middle frame 1 includes a bottom wall 31 and a convex rib 32 that are fastened. A through hole 311 is disposed on the bottom wall 31. The convex rib 32 is located on an outer side of the through hole 311, and the convex rib 32 protrudes from the bottom wall 31 in a direction of the rear cover 10 in the thickness direction Z of the electronic device. The first heat dissipation assembly 5 is mounted on the convex rib 32, and at least a part of the first heat dissipation assembly 5 is located in the through hole 311.

The first middle frame 1 is mainly configured to mount various electronic elements of the electronic device. The first heat dissipation assembly 5 is configured to assist a heat-generating electronic element in heat dissipation. The through hole 311 is disposed on the bottom wall 31 of the first middle frame 1, and a bottom end of the first heat dissipation assembly 5 is built into the through hole 311, to form an embedded structure. Compared with a structure, in the conventional technology, in which the bottom end of the first heat dissipation assembly 5 directly laps with the bottom wall 31, the embedded structure can reduce an overall thickness of the electronic device. As shown in FIG. 13, the convex rib 32 is disposed to protrude from the bottom wall in the direction of the rear cover 10 in the thickness direction Z of the electronic device. The convex rib 32 can enhance local strength of the bottom wall 31 and improve stability. In addition, the convex rib 32 is located on the outer side of the through hole 311, and may be further configured to be connected to the first heat dissipation assembly 5, to implement mounting and locating functions for the first heat dissipation assembly 5. This can prevent the first heat dissipation assembly 5 from shaking in a use process of the electronic device, and ensure mounting stability of the first heat dissipation assembly 5.

The bottom wall 31 and the convex rib 32 may be of an integrated structure or a split structure. This is not limited in this embodiment.

It should be noted that to reduce, as much as possible, damage caused by the through hole 311 to structural strength of the first middle frame 1, an area of the through hole 311 should not be excessively large, but should be slightly greater than an area of the first heat dissipation assembly 5.

In a specific embodiment, as shown in FIG. 13, the electronic device provided in this embodiment of this application further includes a reinforcing member 5A. The reinforcing member 5A is fastened to an end that is of the bottom wall 31 and that is away from the convex rib 32, and the reinforcing member 5A covers the through hole 311.

The first middle frame 1 performs specific support and protection functions for the screen 101. When the through hole 311 is disposed on the bottom wall 31, a stress concentration phenomenon is easily generated on the bottom wall 31 around the through hole 311, and a decrease in a bearing area also causes a decrease in the structural strength of the first middle frame 1, affecting reliability of the screen 101. Therefore, the reinforcing member 5A needs to be disposed to reinforce the first middle frame 1 for the hole. As shown in FIG. 13, the reinforcing member 5A is fastened to the bottom wall 31, and can fully cover the through hole 311, to implement a local reinforcement function. This can enhance structural strength of the bottom wall 31 around the through hole 311, thereby improving overall structural strength of the first middle frame 1, and ensuring reliability of the screen 101.

The reinforcing member 5A may be made of a material that has high structural strength and that is not easy to deform, and may be specifically made of a material such as copper, aluminum, titanium, or stainless steel. This is not limited in this embodiment. A thickness of the reinforcing member 5A may be 0.1 mm to 0.2 mm, to ensure that the structural strength of the bottom wall 31 is effectively improved, and may be specifically 0.1 m, 0.12 mm, 0.15 mm, or 0.2 mm, or may be another value within the foregoing range. This is not limited herein.

In addition, the reinforcing member 5A may be fastened to the bottom wall 31 through bonding. Specifically, as shown in FIG. 13, a mounting groove 31A may be disposed on the bottom wall 31. Specifically, the mounting groove 31A is concavely disposed on a surface that is of the bottom wall 31 and that is away from the rear cover 10, glue 5A1 is applied in the mounting groove, and then the reinforcing member 5A is placed in the mounting groove 31A to complete bonding.

In a specific embodiment, as shown in FIG. 13 and FIG. 14, the first heat dissipation assembly 5 includes a fan housing and a fan rotating mechanism 520. The fan housing includes an upper cover 501, a lower cover 502, and a side enclosure 503. The upper cover 501, the lower cover 502, and the side enclosure 503 jointly enclose an accommodation space 504. The fan rotating mechanism 520 is mounted in the accommodation space 504. The upper cover 501 is provided with an air intake hole 505, and the side enclosure 503 is provided with an air exhaust hole 506. The air intake hole 505 and the air exhaust hole 506 separately communicate with the accommodation space 504.

In this embodiment, the first heat dissipation assembly 5 uses an air-cooling heat dissipation manner. Low-temperature cold air enters the accommodation space 504 from the air intake hole 505 and is in contact with the fan rotating mechanism 520. Fan blades of the fan rotating mechanism 520 rotate to accelerate an air flow rate to form an air flow. The air flow can flow from the air exhaust hole 506 to a heat-generating electronic element to perform heat exchange with the electronic element, thereby assisting the electronic element in heat dissipation.

In a specific implementation, with reference to FIG. 13 and FIG. 14, the side enclosure 503 is not disposed to surround the fan rotating mechanism 520 on four sides, but uses a structure that surrounds the fan rotating mechanism 520 on three sides. In this way, an area of the air exhaust hole 506 can be increased, thereby ensuring that an air volume flowing from the accommodation space 504 to the heat-generating electronic element is large enough, and improving heat dissipation effect of the first heat dissipation assembly 5.

In addition, a quantity of fans (including the fan rotating mechanism 520 and the fan housing) is not limited in this embodiment. When the electronic device has a high heat dissipation requirement, a dual-fan structure may be used to improve heat dissipation performance of the electronic device.

In a specific embodiment, as shown in FIG. 14, there is an air intake channel 507 between the upper cover 501 and the rear cover 10, and the air intake channel 507 communicates with the air intake hole 505.

There is a gap between the upper cover 501 and the rear cover 10, to form the air intake channel 507. External low-temperature cold air may flow from the air intake channel 507 to the air intake hole 505. Compared with a manner, in the conventional technology, in which a hole is disposed on the rear cover 10 as the air intake channel 507, this embodiment ensures that integrity and structural strength of the rear cover 10 are not damaged.

In a specific embodiment, at least a part of the convex rib 32 is disposed around the through hole 311, and the side enclosure 503 is fastened to the convex rib 32. Specifically, a mounting ear structure 503A is disposed to protrude from an outer surface of the side enclosure 503, and the fan housing is fastened to the convex rib 32 through the mounting ear structure 503A.

With reference to FIG. 13 and FIG. 15 together, a part of the convex rib 32 is disposed around the through hole 311 to form a three-sided surrounding structure. This can enhance the structural strength of the bottom wall 31 around the through hole 311, and avoid a position of the air exhaust hole 506, to ensure smooth air exhaust from the first heat dissipation assembly 5. The mounting ear structure 503A of the side enclosure 503 can extend in a direction close to the convex rib 32, and laps with an end of the convex rib 32. As shown in FIG. 13 and FIG. 15, in a width direction X of the first heat dissipation assembly 5, mounting ear structures 503A on both two sides of the side enclosure 503 are fastened to the convex rib 32 through a fastener 5015, thereby improving mounting stability of the first heat dissipation assembly 5.

In addition, as shown in FIG. 15, another part of the convex rib 32 can extend in a length direction Y of the first heat dissipation assembly 5, to improve structural strength at another position on the bottom wall 31, thereby improving overall strength of the first middle frame 1.

In a specific embodiment, as shown in FIG. 14, the upper cover 501 includes an upper cover flow-guiding portion 5011, and the lower cover 502 includes a lower cover flow-guiding portion 5021. The upper cover flow-guiding portion 5011 and the lower cover flow-guiding portion 5021 are disposed opposite to each other in the thickness direction Z of the electronic device.

The upper cover flow-guiding portion 5011 and the lower cover flow-guiding portion 5021 are disposed opposite to each other in the thickness direction Z of the electronic device, to form a flow-guiding channel. The flow-guiding channel communicates with the air exhaust hole 506, and is used to guide an air flow flowing from the air exhaust hole 506 to the heat-generating electronic element, to ensure smooth air exhaust from the first heat dissipation assembly 5.

Specifically, as shown in FIG. 14, the lower cover 502 further includes a lower cover body 5022, and the lower cover flow-guiding portion 5021 is connected to the lower cover body 5022, and is inclined relative to the lower cover body 5022 in a direction close to the upper cover 501; and/or the upper cover 501 further includes an upper cover body 5012, and the upper cover flow-guiding portion 5011 is connected to the upper cover body 5012, and is inclined relative to the upper cover body 5012 in a direction away from the lower cover 502.

The lower cover body 5022 and the upper cover body 5012 are configured to jointly enclose the accommodation space 504 with the side enclosure 503. The lower cover flow-guiding portion 5021 is close to the air exhaust hole 506, and is configured to guide an air flow at the air exhaust hole 506. Specifically, the lower cover flow-guiding portion 5021 is inclined relative to the lower cover body 5022 in the direction close to the upper cover 501, to form a slope structure, so that the air flow can climb upward along the slope and then flow to the heat-generating electronic element, to ensure that all air flows in the accommodation space 504 can flow out smoothly, and avoid unsmooth air exhaust from the first heat dissipation assembly 5 caused by blocking of the bottom wall 31.

Additionally/Alternatively, the upper cover flow-guiding portion 5011 is close to a position of the air exhaust hole 506, and is configured to cooperate with the lower cover flow-guiding portion 5021 for guiding. Specifically, the upper cover flow-guiding portion 5011 is inclined relative to the upper cover body 5012 in the direction away from the lower cover 502, to also form a slope structure. Compared with a structure extending in a horizontal direction, the upper cover flow-guiding portion 5011 of the slope structure can increase an air exhaust area of the first heat dissipation assembly 5, and increase an air exhaust volume, thereby further improving heat dissipation effect of the first heat dissipation assembly 5.

In a specific embodiment, as shown in FIG. 14, there is an included angle α between the lower cover flow-guiding portion 5021 and the lower cover body 5022, and the included angle α meets 90°≤α≤170°. The included angle α may be specifically 90°, 120°, 130°, 150°, 165°, or 170°, or may be another value within the foregoing range. This is not limited herein.

In this embodiment, if the included angle α is excessively small (for example, less than 90°), the air exhaust area of the first heat dissipation assembly 5 is not large enough, and the air exhaust volume is excessively small, which affects the heat dissipation effect of the first heat dissipation assembly 5. If the included angle α is excessively large (for example, greater than 170°), the lower cover flow-guiding portion 5021 tends to be substantially horizontal, and performs an excessively small flow-guiding function, and it cannot be ensured that the air flow can climb to a height above the bottom wall 31 and flow to the heat-generating electronic element, which also affects the heat dissipation effect of the first heat dissipation assembly 5. Therefore, when the included angle α between the lower cover flow-guiding portion 5021 and the lower cover body 5022 is 90° to 170°, it can be ensured that air exhaust from the first heat dissipation assembly 5 is smooth and the air volume is large enough.

In a specific embodiment, as shown in FIG. 14, the upper cover 501 further includes an upper cover reinforcing portion 5013. At least a part of the upper cover body 5012 is connected to the upper cover reinforcing portion 5013, and the upper cover reinforcing portion 5013 protrudes relative to the upper cover body 5012 in a direction of the rear cover 10 of the electronic device (namely, a direction away from the lower cover 502).

The upper cover reinforcing portion 5013 protrudes relative to the upper cover body 5012 in the direction of the rear cover 10 of the electronic device, to perform a local reinforcement function. This improves structural strength of the upper cover body 5012 connected to the upper cover reinforcing portion 5013, and further improve strength of the first heat dissipation assembly 5, so that an anti-extrusion capability of the first heat dissipation assembly 5 is improved.

The upper cover reinforcing portion 5013 and the upper cover body 5012 may be of an integrated structure, or may be of a split structure. This is not limited in this embodiment. A thickness of the upper cover reinforcing portion 5013 may be 0.4 mm to 0.8 mm, to ensure that the structural strength of the upper cover body 5012 is effectively improved, and may be specifically 0.4 mm, 0.5 mm, 0.6 mm, or 0.8 mm, or may be another value within the foregoing range. This is not limited herein.

In a specific embodiment, as shown in FIG. 15, the upper cover body 5012 is provided with a connecting portion 5014. The connecting portion 5014 is connected to the upper cover reinforcing portion 5013. The connecting portion 5014 is disposed at each of two ends of the upper cover body 5012 in the width direction X of the first heat dissipation assembly 5, and the two connecting portions 5014 are separately fastened to the convex rib 32. For example, the connecting portions 5014 and the upper cover reinforcing portion 5013 may be of an integrated structure. The upper cover reinforcing portion 5013 is of a strip structure, and a length direction of the upper cover reinforcing portion 5013 is the first direction X. The connecting portions 5014 are located at two ends of the upper cover reinforcing portion 5013 in the length direction. The connecting portions 5014 are equivalent to structures that protrude from the two ends of the upper cover reinforcing portion 5013 and that extend to a periphery of the upper cover. Lapping with the convex rib 32 is implemented through the connecting portion 5014, and a connection to the first middle frame 1 is implemented through a fastener.

In this embodiment, in the first direction X (the axial direction of the rotating shaft of the electronic device), the two connecting portions 5014 are separately fastened to the convex rib 32, to further improve mounting stability of the first heat dissipation assembly 5. As shown in FIG. 15, the connecting portion 5014 is connected to the upper cover reinforcing portion 5013, and the connecting portion 5014 connects convex ribs 32 located on two sides of the first heat dissipation assembly 5 to integrally form an annular reinforcement structure, so as to further perform a reinforcement function, and improve structural strength of the first middle frame 1. In addition, more even force distribution on the convex rib 32 can be implemented, and structural stability of the convex rib 32 can be improved.

The connecting portion 5014 may be fastened to the convex rib 32 through a fastener 5015. The fastener 5015 may be specifically a screw or another connecting piece. This is not limited in this embodiment.

In a specific embodiment, the electronic device further includes a flexible circuit board 6A. A groove is disposed at an end that is of the lower cover 502 and that is away from the fan rotating mechanism 520, that is, a groove is disposed on an outer surface of the lower cover 502. At least a part of the flexible circuit board 6A is mounted in the groove.

One end of the flexible circuit board 6A is connected to the first heat dissipation assembly 5, and the other end is connected to a mainboard of the electronic device. As shown in FIG. 13, a groove (for example, manufactured by using an etching process) may be disposed at the end that is of the lower cover 502 and that is away from the fan rotating mechanism 520, and then the flexible circuit board 6A is mounted in the groove, that is, the flexible circuit board 6A is built into a bottom wall of the lower cover 502. Compared with a solution, in the conventional technology, in which the flexible circuit board 6A is directly attached to the bottom wall of the lower cover 502, this can reduce a thickness of the electronic device, which helps implement lightness and thinness of the electronic device.

In conclusion, according to the electronic device provided in this embodiment, the thickness of the electronic device can be reduced without affecting the heat dissipation effect of the first heat dissipation assembly 5, and the structural strength of the first middle frame 1 is improved by disposing the reinforcing member 5A and the upper cover reinforcing portion 5013, thereby improving reliability of the first heat dissipation assembly 5 and the screen 101, and ensuring that the fan and the screen 101 do not fail in a use process of the electronic device.

FIG. 16 to FIG. 21 are diagrams of a part combining a first middle frame and a fan according to an implementation of this application. This implementation is slightly different from specific structures in the implementations provided in FIG. 13 to FIG. 15. For example, specific structures of the upper cover and the lower cover of the fan housing are different, and in particular, related structures of the upper cover and the lower cover at an air exhaust vent position are different.

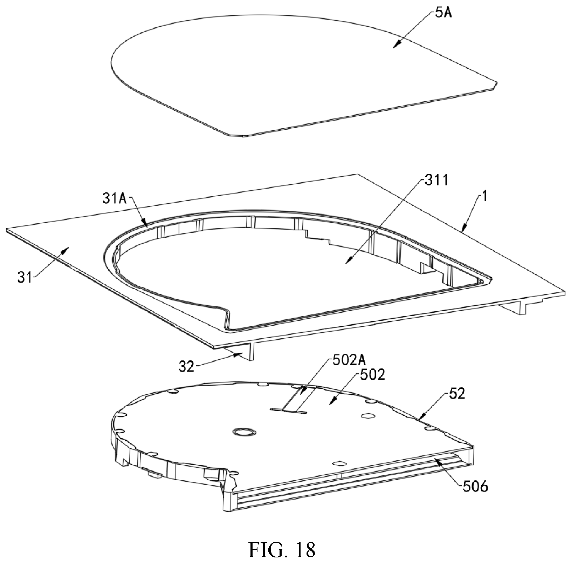

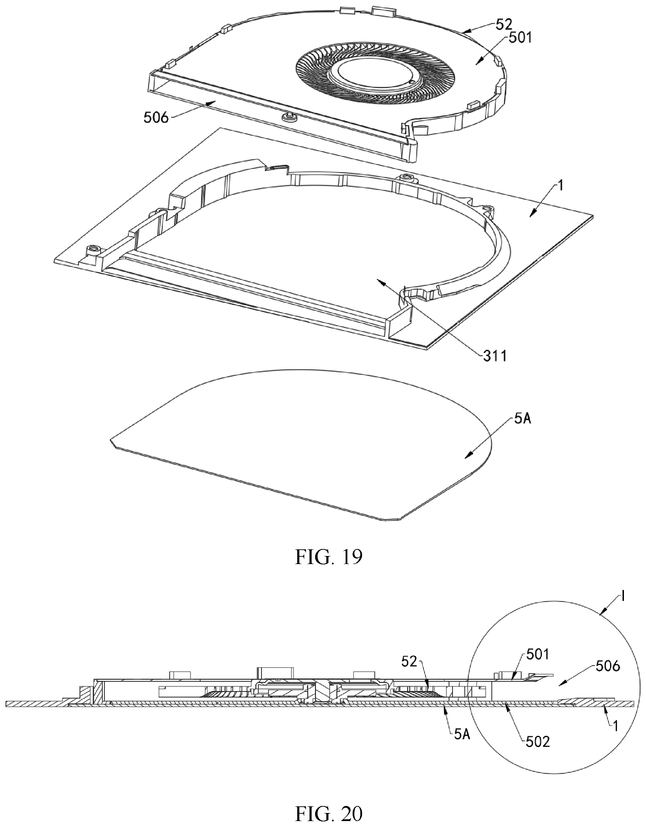

FIG. 16 is a three-dimensional diagram of a part combining a first middle frame and a fan in an electronic device in a direction according to an embodiment of this application. FIG. 17 is a three-dimensional diagram of the structure shown in FIG. 16 in another direction. FIG. 18 is a three-dimensional exploded view of the structure shown in FIG. 17. FIG. 19 is a three-dimensional exploded view of the structure shown in FIG. 18 in another direction.

With reference to FIG. 16, FIG. 17, FIG. 18, and FIG. 19, in an implementation, the first middle frame 1 is provided with a through hole 311. A shape of the through hole 311 matches a shape of the fan 52. Specifically, the first middle frame 1 includes a bottom wall 31 and a convex rib 32. The convex rib 32 is disposed to protrude from the bottom wall 31, and the convex rib 32 forms, through enclosing, a space that is used to accommodate the fan 52 and that matches the shape of the fan 52. In an implementation, as shown in FIG. 16 to FIG. 18, the bottom wall 31 includes a top surface 31S1 and a bottom surface 31S2. In the electronic device, the top surface 31S1 faces the rear cover of the electronic device, and the bottom surface 31S2 faces the screen of the electronic device. The convex rib 32 protrudes from the top surface, a mounting groove 31A is concavely disposed on the bottom surface of the bottom wall 31, and the mounting groove 31A surrounds the through hole 311. A shape of an outer edge of the mounting groove 31A is the same as a shape of an outer contour of the reinforcing member 5A. As shown in FIG. 17, in an implementation, the reinforcing member 5A is located in the mounting groove 31A and is fastened to the bottom wall 31, and a surface of the reinforcing member 5A may be flush and coplanar with a surface of the bottom wall 31.

In an implementation, a surface that is of the lower cover 502 of the housing of the fan 52 and that faces away from the upper cover 501 may be attached to the reinforcing member 5A (the surface and the reinforcing member 5A may be bonded and fastened through adhesive, or the surface and the reinforcing member 5A may be in direct contact). In another implementation, a spacer may alternatively be disposed between a surface that is of the lower cover 502 and that faces away from the upper cover 501 and a surface of the reinforcing member 5A. For example, the spacer may be foam, and the spacer may be configured to buffer vibration of the fan.

In an implementation, a groove 502A may be disposed on the surface that is of the lower cover 502 and that faces away from the upper cover 501, and the groove 502A is configured to dispose a flexible circuit board. The flexible circuit board may be attached to or in contact with the reinforcing member 5A.

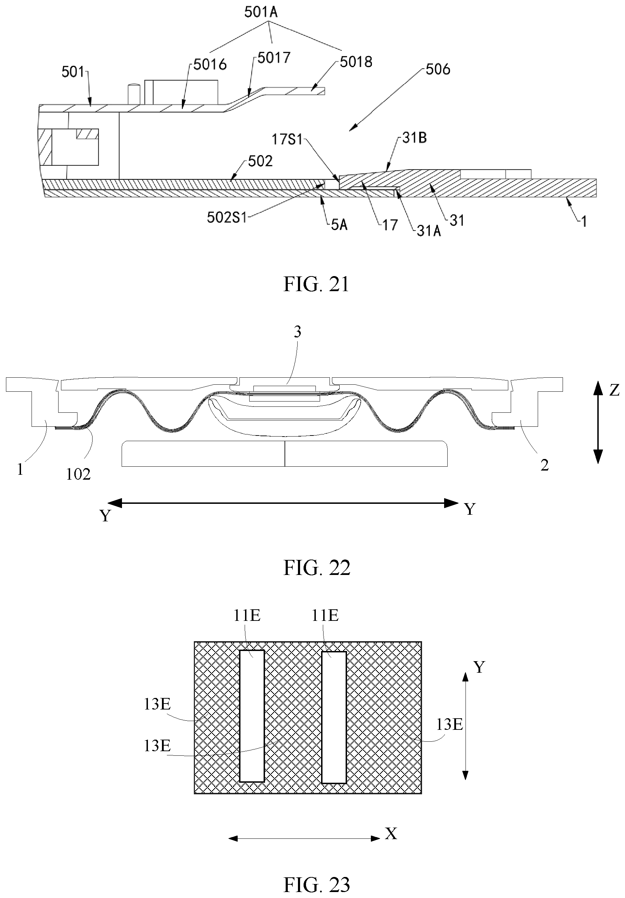

FIG. 20 is a cross-sectional view of an assembly structure combining a first middle frame and a fan according to an implementation of this application. FIG. 21 is an enlarged view of a part I in FIG. 20. With reference to FIG. 20 and FIG. 21, in an implementation, the lower cover 502 of the housing of the fan 52 is in a flat plate shape, an edge that is of the lower cover 502 and that corresponds to the air exhaust vent 506 includes a flat plate-shaped structure, and the flat plate-shaped structure is close to the air exhaust vent. The edge that is of the lower cover 502 and that corresponds to the air exhaust vent 506 is adjacent to an edge region 17 of the bottom wall 31 of the first middle frame 1. The lower cover 502 includes a side end face 502S1, and the side end face 502S1 directly faces the first middle frame 1 and the edge region 17. The edge region 17 includes a side end face 17S1, and the side end face 17S1 of the edge region directly faces the side end face 502S1 of the lower cover 502. In an implementation, there is a gap between the side end face 17S1 of the edge region and the side end face 502S1 of the lower cover 502. In an implementation, the side end face 17S1 of the edge region may alternatively be in contact with the side end face 502S1 of the lower cover 502. A mounting groove 31A is concavely disposed on a bottom surface of the edge region 17, and an edge of the reinforcing member 5A is located in the mounting groove 31A and laps with the edge region 17. In an implementation, the edge region 17 has an air-guiding inclined surface 31B. The air-guiding inclined surface 31B is inclined and extends relative to the flat plate-shaped structure, and the air-guiding inclined surface 31B is configured to guide air in the accommodation space of the fan housing from the air exhaust vent to an outside of the housing.

In an implementation, an edge that is of the upper cover 501 and that is adjacent to the air exhaust vent 506 is an air-guiding structure 501A. The air-guiding structure 501A includes a first part 5016, a second part 5017, and a third part 5018 that are sequentially connected. In an implementation, the first part 5016, the second part 5017, and the third part 5018 are of an integrated structure, for example, may be an integrated sheet metal part. The first part 5016 and a central region of the upper cover 501 are coplanar. This may be understood as that the first part 5016 and the central region of the upper cover 501 jointly form the flat plate-shaped structure. The first part 5016 may be perpendicular to a thickness direction of the first middle frame 1. The second part 5017 is inclined and extends relative to the first part 5016. The third part 5018 may be parallel to the first part 5016, and a diameter of the air exhaust vent 506 corresponding to the third part 5018 is greater than a diameter of the air exhaust vent 506 corresponding to the first part 5016. A part of a diameter of the air exhaust vent 506 corresponding to the second part 5017 is in a gradually expanding form.

In an implementation, the first part 5016 is parallel to an inner surface of the lower cover 502, and an angle at which the second part 5017 is inclined relative to the first part 5016 may be the same as an angle at which the air-guiding inclined surface 31B is inclined relative to the inner surface of the lower cover 502.

In an implementation, an edge of the upper cover 501 and an edge of the lower cover 502 of the fan housing are aligned in the thickness direction of the electronic device.

Any one of the possible implementations shown in FIG. 13 to FIG. 21 may be applied to any one of the possible implementation solutions shown in FIG. 4 to FIG. 12.

For a foldable display device, use of the foregoing distributed heat source design may result in an increase in a requirement for cross-axis communication between components distributed on two sides of a rotating shaft, and consequently a quantity of signal lines on a flexible circuit board (FPC) increases sharply, which may cause a wider width of the FPC. However, due to existence of an assembly tolerance of the FPC, in a folding process of the electronic device, an excessively wide FPC has a problem of distortion in a width direction of the FPC, severely affecting a bending life of the FPC. For ease of description, a length direction of the FPC is defined as a second direction Y. In the electronic device, the length direction of the FPC is perpendicular to an axial direction of the rotating shaft. The width direction of the FPC is defined as a first direction X (namely, the axial direction of the rotating shaft). The first direction X is perpendicular to the second direction Y. The FPC is distorted in the second direction Y. Consequently, a part of a portion at one end of the FPC in the first direction X is compressed, and a part of a portion at the other end is stretched. The distortion problem of the FPC severely affects the bending life of the FPC.

In an embodiment of this application, a strip-shaped hole is disposed on the flexible circuit board, so that a part that is on the flexible circuit board and that is located between a first middle frame and a second middle frame can be separated into a plurality of transmission segments with a small width, to avoid excessively significant twisting of the flexible circuit board in a bending process, thereby prolonging a service life of the flexible circuit board.

FIG. 22 is a partial view of an electronic device in a flattened state according to an embodiment of this application. With reference to FIG. 22, FIG. 22 shows an example of a connection state between some parts at a position of a rotating shaft assembly in a foldable smartphone. The electronic device includes a first middle frame 1, a second middle frame 2, a flexible circuit board 102, and a rotating shaft 3. A screen may be carried above the first middle frame 1, the second middle frame 2, and the rotating shaft 3. The flexible circuit board 102 may pass through the rotating shaft 3, and two ends of the flexible circuit board 102 may be respectively connected to the first middle frame 1 and the second middle frame 2.

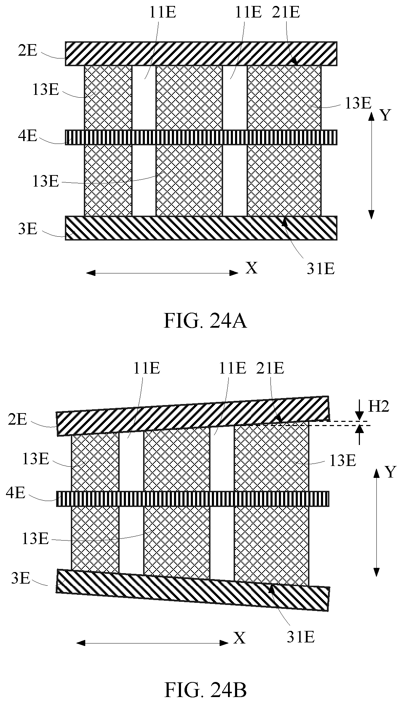

FIG. 23 is a diagram of a structure of a flexible circuit board according to an embodiment of this application. FIG. 24A is a state diagram of a flexible circuit board during application according to an embodiment of this application. FIG. 24B is another state diagram of a flexible circuit board 102 during application according to an embodiment of this application.

With reference to FIG. 23, at least one strip-shaped hole 11E is disposed on the flexible circuit board, the strip-shaped hole 11E extends in the first direction X, and the strip-shaped hole 11E separates a wide middle part of the flexible circuit board into a plurality of transmission segments 13E with a small width. As shown in FIG. 23, two strip-shaped holes 11E are disposed, and the middle part of the flexible circuit board is separated into three transmission segments 13E whose widths are unequal. The widths of the transmission segments 13E may alternatively be equal. To ensure integrated integrity of the flexible circuit board, the strip-shaped hole 11E cannot penetrate through two ends of the flexible circuit board in the second direction Y. That is, the two ends of the flexible circuit board are still of an integrated structure, but a middle region is separated into a plurality of transmission segments 13E, and the plurality of transmission segments 13E are interconnected at two ends to form an integrated structure. In this way, it is convenient to fasten to the flexible circuit board, the first middle frame, and the second middle frame.

With reference to FIG. 23, FIG. 24A, and FIG. 24B, the electronic device provided in this embodiment of this application includes a first fastening portion 2E, a rotating portion 4E, a second fastening portion 3E, and at least one layer of flexible circuit board 102. The second fastening portion 3E and the first fastening portion 2E are respectively located on two sides of the rotating portion 4E in the second direction Y, and the first fastening portion 2E and the second fastening portion 3E may rotate relative to the rotating portion 4E. The first fastening portion 2E and the second fastening portion 3E may be a housing, a middle frame, or the like of the electronic device, or may be a fastening structure independent of a housing or a middle frame. Functional components may be arranged on the first fastening portion 2E and the second fastening portion 3E. For the electronic device being a foldable smartphone, the rotating portion 4E may be at least a part of the rotating shaft 3 shown in FIG. 22, and the first fastening portion 2E and the second fastening portion 3E can be separately rotatably connected to the rotating shaft 3, so that the first fastening portion 2E and the second fastening portion 3E can rotate relative to the rotating shaft 3. For example, the first fastening portion 2E and the second fastening portion 3E may alternatively be independent structural members, for example, metal sheets. The first fastening portion 2E and the second fastening portion 3E may be mounted on the housing and the middle frame of the electronic device, and can enhance a connection and structural strength of the flexible circuit board 102.

The first fastening portion 2E fastens one end of the flexible circuit board to the first middle frame, and the second fastening portion 3E fastens the other end of the flexible circuit board to the second middle frame. It may be understood that the first fastening portion 2E and the second fastening portion 3E are respectively disposed to overlap the two ends of the flexible circuit board. In the implementations shown in FIG. 24A and FIG. 24B, the first fastening portion 2E and the second fastening portion 3E shield two ends of the strip-shaped hole 11E, and shield the two ends of the flexible circuit board.

With reference to FIG. 24B, the strip-shaped hole 11E is disposed between the first fastening portion 2E and the second fastening portion 3E, and the strip-shaped hole 11E can separate a part that is on the flexible circuit board 102 and that is located between the first fastening portion 2E and the second fastening portion 3E into a plurality of transmission segments 13E. Therefore, each transmission segment 13E may have a small width. For example, a width of each transmission segment 13E in the first direction X may be controlled within 15 mm. Different transmission segments 13E may have a same width or different widths. In a folding process of the electronic device, the transmission segment 13E with a small width is not prone to twisting.

With reference to FIG. 24B, even if there is twisting in the transmission segment 13E, because the transmission segment 13E has a small width, a twisting amount H2 of the transmission segment 13E in the second direction Y may be controlled within 1.5 mm. In addition, because two adjacent transmission segments 13E are separated by the strip-shaped hole 11E, states of the two adjacent transmission segments 13E do not affect each other, and impact of this minor twisting amount on a fatigue life of the flexible circuit board 102 may be ignored.

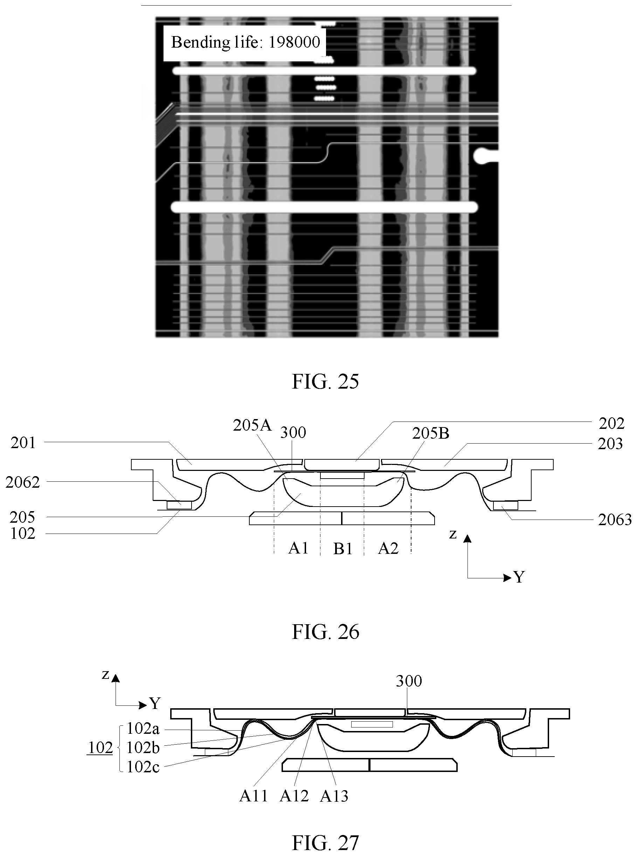

FIG. 25 is a simulation diagram of a bending life of a flexible circuit board according to this application. With reference to FIG. 25, the flexible circuit board with a strip-shaped hole has a life of 198000 times during application.

Therefore, in this embodiment, the strip-shaped hole 11E is disposed on the flexible circuit board 102, so that a part that is on the flexible circuit board 102 and that is located between the first fastening portion 2E and the second fastening portion 3E can be separated into a plurality of transmission segments 13E with a small width, to avoid significant twisting of the flexible circuit board 102 in a folding process of the electronic device, thereby prolonging a service life of the flexible circuit board 102.

A width of the strip-shaped hole 11E in the first direction X may be greater than or equal to 1 mm, to ensure that a distortion amount of the flexible circuit board 102 is fully absorbed through the strip-shaped hole 11E, thereby ensuring overall stability of the flexible circuit board 102. Certainly, in some other application scenarios, the width of the strip-shaped hole 11E may alternatively be less than 1 mm. This is not limited in this embodiment.

In a specific implementation, with reference to FIG. 23, FIG. 24A, and FIG. 24B, a length of the strip-shaped hole 11E in the second direction Y is greater than or equal to a distance between the first fastening portion 2E and the second fastening portion 3E.

With reference to FIG. 24A and FIG. 24B, the first fastening portion 2E may be fastened to an edge position that is of the first middle frame and that is adjacent to the rotating shaft, the second fastening portion 3E may be fastened to an edge position that is of the second middle frame and that is adjacent to the rotating shaft, and the first fastening portion 2E and the second fastening portion 3E are disposed opposite to each other on two sides of the rotating shaft. An inner edge 21E of the first fastening portion 2E is an edge that is of the first fastening portion 2E and that faces the rotating shaft, and an inner edge of the second fastening portion 3E is an edge that is of the second fastening portion 3E and that faces the rotating shaft. A part that is on the flexible circuit board 102 and that is prone to twisting is located at a position at which the flexible circuit board 102 is aligned with the inner edge 21E of the first fastening portion 2E. The inner edge 21E of the first fastening portion 2E is an edge that is of the first fastening portion 2E and that faces a side surface of the second fastening portion 3E. Similarly, the part that is on the flexible circuit board 102 and that is prone to twisting is further located at a position at which the flexible circuit board 102 is aligned with the inner edge 31E of the second fastening portion 3E. The inner edge 31E of the second fastening portion 3E is an edge that is of the second fastening portion 3E and that faces a side surface of the first fastening portion 2E. In this embodiment, the length of the strip-shaped hole 11E in the second direction Y is greater than or equal to the distance between the first fastening portion 2E and the second fastening portion 3E, to ensure that the ends of the strip-shaped hole 11E can extend to the inner edge 21E of the first fastening portion 2E and the inner edge 31E of the second fastening portion 3E, so that two adjacent transmission segments 13E can be separated by the strip-shaped hole 11E at positions of the inner edge 21E of the first fastening portion 2E and the inner edge 31E of the second fastening portion 3E. In this way, each transmission segment 13E has a small width at each of a position at which the transmission segment is aligned with the inner edge 21E of the first fastening portion 2E and a position at which the transmission segment is aligned with the inner edge 31E of the second fastening portion 3E, and the transmission segments 13E do not affect each other, thereby effectively reducing a twisting amount and prolonging the service life of the flexible circuit board 102.

All the possible implementations shown in FIG. 22 to FIG. 25 may be applied to the implementations shown in FIG. 4 to FIG. 21. In a specific embodiment, the flexible circuit board passes through the shaft, so that components distributed on the two sides of the rotating shaft are electrically connected. In the solution in which the flexible circuit board passes through the rotating shaft, in a folding process of the electronic device, a flexible circuit board at a position of a shaft region may generate an abnormal sound. How to resolve an abnormal sound generated in a process of opening/closing the foldable display device is an urgent problem to be resolved currently. To resolve a problem that a bendable portion of the flexible circuit board generates an abnormal sound in a process of opening/closing the foldable display device at a large angle, a problem of a sudden form change of the bendable portion needs to be first resolved. The sudden form change of a structure may be limited by introducing a new structure.

The flexible circuit board 102 in the following implementation example may be a specific solution of the electrical connection structure 8 disclosed in the foregoing embodiments. This may also be understood as that in the electronic device, the electrical connection structure 8 includes the flexible circuit board 102.

FIG. 26 is a diagram of an electronic device according to an implementation of this application. In FIG. 26, a horizontally extending direction is a second direction Y (a length direction of the electronic device), and a vertically extending direction is a third direction Z (a thickness direction of the electronic device). With reference to FIG. 26, in an implementation, a rotating shaft (or referred to as a rotating shaft assembly or a rotating shaft structure) of the electronic device includes a first door panel 201, a second door panel 202, a third door panel 203, and a hinge structure 205. The electronic device includes a flexible circuit board 102 and a limiting structure 300. The flexible circuit board 102 passes through the rotating shaft. The flexible circuit board 102 is specifically limited at a position of the rotating shaft through the limiting structure 300, to resolve a problem that a bendable portion of the flexible circuit board generates an abnormal sound in a process of opening/closing the foldable display device at a large angle. The first door panel 201 and the third door panel 203 are located on two opposite sides of the second door panel 202. The hinge structure 205 is located on one side of the second door panel 202. The hinge structure 205 may be a part of the rotating shaft of the electronic device, and directly faces the second door panel 202. Both the first door panel 201 and the third door panel 203 are rotatably connected to the hinge structure 205. In a direction from the second door panel 202 to the first door panel 201, the flexible circuit board 102 includes a first fastening portion B1 and a first bendable-portion part A1 connected to the first fastening portion. The first fastening portion B1 is fastened to a side that is of the second door panel and that faces the hinge structure 205. The limiting structure 300 is disposed on a side that is of the flexible circuit board 102 and that faces the second door panel 202, and the limiting structure 300 covers at least a part of the first bendable-portion part A1.

In a possible implementation, the limiting structure 300 is connected to the second door panel 202, and the limiting structure 300 is connected to the flexible circuit board 102. A process of fastening the limiting structure 300 to the second door panel 202 and the flexible circuit board 102 is not limited in this embodiment of this application. For example, the limiting structure 300 may be directly connected to the second door panel 202 and the flexible circuit board 102 through an adhesive layer. For example, a hot pressing process may be used. The hot pressing process may be understood as converting the adhesive layer into a semi-solid state with viscosity at a specific temperature, so that the limiting structure 300 is bonded to the flexible circuit board 102.

It may be understood that the first fastening portion B1 in this embodiment of this application is a part that connects the flexible circuit board 102 and the second door panel 202. Because of a physical property of the flexible circuit board 102, each segment on the flexible circuit board 102 has a bendable feature. The bendable portion in this embodiment of this application is specifically a part that generates a sudden form change in the process of opening/closing the foldable display device. The bendable portion is usually structurally located in a part that is on the flexible circuit board 102 and that is connected to the first fastening portion B1. For example, as shown in FIG. 26, the bendable portion includes the first bendable-portion part A1 and a second bendable-portion part A2.

In the process of opening/closing the foldable display device at a large angle, the bendable portion is subjected to extrusion force pointing to a rotation center and elastic force for restoring a shape of the bendable portion. The limiting structure 300 exerts force on the flexible circuit board 102, to balance elastic force and extrusion force on the first bendable portion A1 of the flexible circuit board 102, limit deformation of the flexible circuit board 102, and effectively suppress the problem of a sudden form change in the process of opening/closing the foldable display device, thereby alleviating the problem that an abnormal sound is generated in the process of opening/closing the foldable display device at a large angle.

FIG. 27 is a diagram of a two-dimensional structure of a foldable display device that is in an unfolded state and to which a limiting structure is added according to an embodiment of this application. In FIG. 27, a horizontally extending direction is a second direction Y (a length direction of the electronic device), and a vertically extending direction is a third direction Z (a thickness direction of the electronic device). In the implementation shown in FIG. 27, the flexible circuit board 102 is more specific than that in the implementation shown in FIG. 26. The flexible circuit board of the electronic device provided in this application includes a segmentation slot.

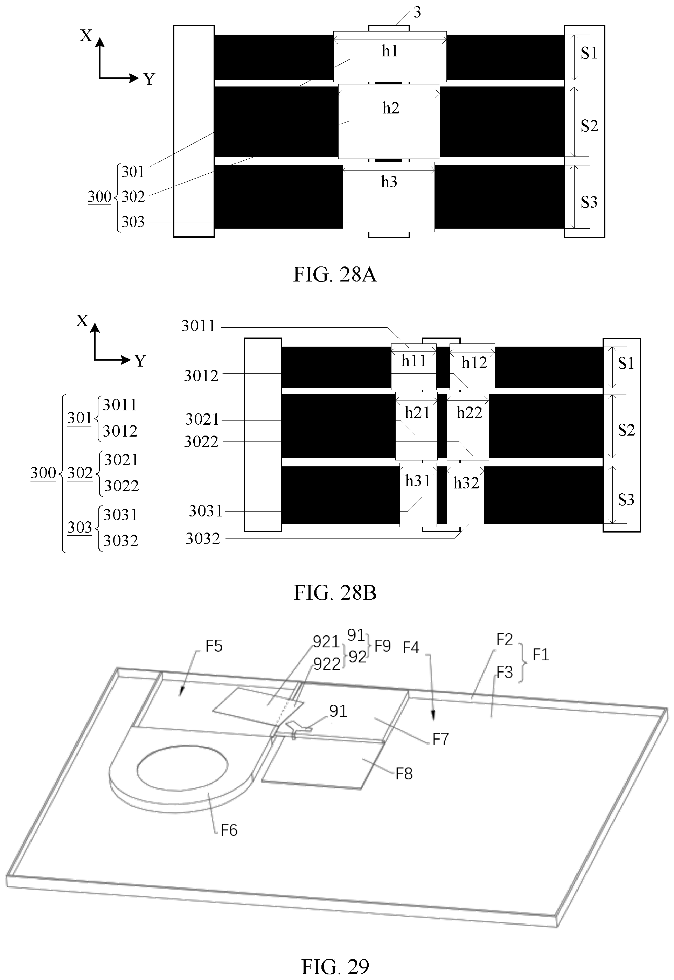

FIG. 28A is a diagram of a two-dimensional structure of a foldable display device from another angle according to an implementation of this application, where sizes of three limiting structures may be different. FIG. 28B is a diagram of another implementation of the limiting structure in FIG. 28A. In FIG. 28A and FIG. 28B, a horizontally extending direction is a second direction Y, and a vertically extending direction is a first direction X (an axial direction of the rotating shaft 3).

In a possible implementation, as shown in FIG. 28A, a size of the first bendable portion in the first direction (the X direction shown in FIG. 27) is S1, a size of the second bendable portion in the first direction X is S2, and S1 is not equal to S2. A size of a first limiting structure 301 in the second direction (the Y direction shown in FIG. 27) is h1, a size of the second limiting structure 302 in the second direction is h2, and h1 is not equal to h2. The first direction X is parallel to a length direction of the hinge structure (the first direction is also the axial direction), and the second direction Y is parallel to an arrangement direction of the first door panel, the second door panel, and the third door panel.

A size in the first direction X is defined as a width, and a size in the second direction Y is defined as a length. When widths of two segments of flexible circuit boards on two sides of the segmentation slot are different, form changes of the two segments of flexible circuit boards in the process of opening/closing the foldable display device are different. In addition, a narrower flexible circuit board indicates greater elastic force or extrusion force generated in the process of opening/closing the foldable display device and requires a longer limiting structure.

In a possible implementation, with reference to FIG. 27 and FIG. 28B, a first segment 102a includes a first segment A11 of the first bendable portion, a second segment 102b includes a second segment A12 of the first bendable portion, and a third segment 102c includes a third segment A13 of the first bendable portion. The limiting structure 300 includes the first limiting structure 301, the second limiting structure 302, and a third limiting structure 303. The first limiting structure 301 includes a first block 3011 and a second block 3012, the second limiting structure 302 includes a third block 3021 and a fourth block 3022, and the third limiting structure 303 includes a fifth block 3031 and a sixth block 3032. The first block 3011 covers at least a part of the first segment A11 of the first bendable portion, the third block 3021 covers at least a part of the second segment A12 of the first bendable portion, and the fifth block 3031 covers at least a part of the third segment A13 of the first bendable portion. A size of the first segment of the first bendable portion in the first direction (the X direction shown in FIG. 28A) is S1, a size of the second segment of the first bendable portion in the first direction is S2, and a size of the third segment of the first bendable portion in the first direction is S3. A size of the first block 3011 in the second direction (the Y direction shown in FIG. 28A) is h11, a size of the second block 3012 in the second direction is h21, and a size of the third block 3021 in the second direction is h31. Because S1<S2<S3, h11>h21>h31.

In a possible implementation, when the flexible circuit board is a multilayer flexible circuit board, each layer of flexible circuit board has a flexible substrate. For example, the multilayer flexible circuit board includes two layers disposed in a stacked manner. An inner layer is a first layer, and includes a first flexible substrate. An outer layer is a second layer, and includes a second flexible substrate. When other layers inside the flexible circuit board are ignored, the first flexible substrate and the second flexible substrate are disposed in a stacked manner, and in terms of a position, the first flexible substrate is closer to the second door panel than the second flexible substrate. For example, the inner layer is a layer adjacent to the door panel, and the outer layer is a layer away from the door panel.

In some other examples, in the bendable portion, an elastic modulus of the first flexible substrate is equal to an elastic modulus of the second flexible substrate.

In some other examples, in the bendable portion, an elastic modulus of the first flexible substrate is less than an elastic modulus of the second flexible substrate.

That is, the inner layer uses the first flexible substrate with a small elastic modulus, and another layer uses the second flexible substrate with a large elastic modulus. For example, the elastic modulus of the first flexible substrate is less than 4 GPa, and the elastic modulus of the second flexible substrate is greater than 6 GPa. In this way, rigidity of the inner layer is less than rigidity of another layer. Therefore, a probability of a sudden form change of the inner layer can be reduced, thereby reducing a probability of a sudden form change of the flexible circuit board, and reducing a probability of generating an abnormal sound in the process of opening/closing the foldable display device.

For example, the multilayer flexible circuit board includes three layers: an inner layer, a middle layer, and an outer layer. For example, the inner layer is a layer adjacent to the door panel, and the outer layer is a layer away from the door panel. The inner layer uses a first flexible substrate, and an elastic modulus is 3 GPa. The middle layer and the outer layer use a second flexible substrate, and an elastic modulus is 6.5 GPa.

In a possible implementation, the flexible circuit board further includes a third flexible substrate. The second flexible substrate is located between the first flexible substrate and the third flexible substrate. In the bendable portion, the elastic modulus of the second flexible substrate is less than or equal to an elastic modulus of the third flexible substrate.

That is, the inner layer uses the first flexible substrate with a small elastic modulus, the middle layer uses the second flexible substrate with a large elastic modulus, and the outer layer uses the third flexible substrate. For example, the elastic modulus of the first flexible substrate is less than 4 GPa, the elastic modulus of the second flexible substrate is greater than 4 GPa and less than 6 GPa, and the elastic modulus of the third flexible substrate is greater than 6 GPa.

In this way, rigidity of the inner layer is less than rigidity of the middle layer and rigidity of the outer layer, the rigidity of the middle layer is less than the rigidity of the outer layer, and a gradient distribution is used for rigidity of different layers of the flexible circuit board. Therefore, a probability of a sudden form change of the inner layer can be reduced, thereby reducing a probability of a sudden form change of the flexible circuit board, and reducing a probability of generating an abnormal sound in the process of opening/closing the foldable display device.

For example, the multilayer flexible circuit board has three layers: an inner layer, a middle layer, and an outer layer. For example, the inner layer is a layer adjacent to the door panel, and the outer layer is a layer away from the door panel. The inner layer uses a first flexible substrate, and an elastic modulus is 3 GPa. The middle layer uses a second flexible substrate, and an elastic modulus is 5 GPa. The outer layer uses a third flexible substrate, and an elastic modulus is 6.5 GPa.

For example, the multilayer flexible circuit board has four layers: an inner layer, a first middle layer, a second middle layer, and an outer layer. The inner layer uses a first flexible substrate, and an elastic modulus is 3 GPa. Both the first middle layer and the second middle layer use a second flexible substrate, and an elastic modulus is 5 GPa. The outer layer uses a third flexible substrate, and an elastic modulus is 6.5 GPa.

The embodiments in FIG. 26 to FIG. 28B may be applied to any one of the possible implementations shown in FIG. 4 to FIG. 25. In the embodiments in FIG. 26 to FIG. 28B, a specific structural design related to the flexible circuit board of the foldable display device is provided based on the problem of an abnormal sound generated by a sudden form change of the flexible circuit board in the process of opening/closing the foldable display device at a large angle, to resolve the problem of a sudden form change of the bendable portion of the flexible circuit board and the problem of generating an abnormal sound in the large-angle opening/closing process.

FIG. 29 is a diagram of a partial structure of an electronic device according to an implementation of this application. FIG. 29 shows a specific solution for disposing an antenna in an electronic device 100. One part of a radiator of the antenna is carried through a support member (for example, a sound cavity housing of an audio module), and the other part of the radiator of the antenna is carried through a rear cover. An antenna signal is transmitted through coupling between the two parts of radiators. The radiator of the antenna directly faces an air exhaust channel of a fan, but does not need to occupy the air exhaust channel, to ensure heat dissipation efficiency, and facilitate a thin design of the electronic device.

With reference to FIG. 29, in an implementation, the electronic device includes a middle frame F1, a support member F7, a circuit board F8, a first antenna sub-portion 91, and a second antenna sub-portion 92. An inner cavity F4 and an air duct F5 are formed between the rear cover of the electronic device and the middle frame F1. Both the circuit board F8 and the support member F7 are mounted in the inner cavity F4. The first antenna sub-portion 91 is fastened to a side that is of the support member F7 and that faces the rear cover, and is electrically connected to the circuit board F8. In an implementation, a radio frequency chip is disposed on the circuit board F8, and the radio frequency chip is electrically connected to the first antenna sub-portion 91 through a radio frequency cable, to feed the first antenna sub-portion 91. The second antenna sub-portion 92 is fastened to a surface that is of the rear cover and that faces the middle frame F1, and the second antenna sub-portion 92 may be a patch structure attached to an inner surface of the rear cover. A region that is of the rear cover and that is used to carry the second antenna sub-portion is a non-signal shielding region, that is, an insulating material, and the non-signal shielding region allows a signal to pass through. The non-signal shielding region may be made of a non-conductive material. The non-conductive material may be glass fiber, ceramic, plastic, or the like. An electromagnetic wave signal is transferred between the first antenna sub-portion and the second antenna sub-portion through coupling, and the first antenna sub-portion and the second antenna sub-portion jointly form the radiator of the antenna.

In this solution, the second antenna sub-portion is at least partially located on the inner surface of the rear cover and can transmit a signal through the rear cover, and the antenna radiator is disposed through the rear cover. In this way, the second antenna sub-portion does not occupy a space of the air duct F5, and a circulation area of the air exhaust channel of the fan F6 can be ensured. Therefore, in this solution, heat dissipation performance of the antenna can be ensured, and the air duct F5 of the electronic device provides a good clearance environment for the antenna, which helps ensure performance of the antenna. Therefore, in this solution, radiation performance of the antenna can also be ensured, and the antenna can have better bandwidth and radiation efficiency.

In an implementation, a feed circuit is disposed on the circuit board F8, and the feed circuit may feed the first antenna sub-portion 91.

In some possible implementations, the second antenna sub-portion 92 is a flexible printed circuit board or a metal part. In this case, the second antenna sub-portion has a simple structure and is easy to implement.

In some possible implementations, the second antenna sub-portion 92 is a conductive heat dissipation member. For example, the second antenna sub-portion 92 may be a graphite sheet. The graphite sheet is easy to cut, making it easier to meet a heat dissipation requirement and an antenna design requirement, and has low costs. The graphite sheet may be assembled and fastened to the rear cover through bonding or in another manner. The graphite sheet is designed into a shape of the antenna radiator, to ensure that an electrical length of the graphite sheet meets a requirement for antenna radiation. In this implementation, the electronic device reuses the heat dissipation member as the second antenna sub-portion. In this way, not only a heat dissipation function of the heat dissipation member can be retained, but also the air duct F5 can carry away heat from the heat dissipation member, to carry away heat from another component thermally connected to the heat dissipation member in the electronic device, so as to ensure heat dissipation performance of the electronic device. In addition, antenna performance of the electronic device can be improved without adding an additional structural member. Therefore, implementation difficulty is low, and costs are low.

In some embodiments, the second antenna sub-portion 92 may include a first part 921 and a second part 922. The second part 922 is connected to the first part 921. The first part 921 is disposed to directly face the air duct F5. In a thickness direction of the electronic device, the second part 922 directly faces the first antenna sub-portion 91 on the support member F7. A design in which the second part 922 directly faces the first antenna sub-portion 91 helps provide an appropriate spacing and facilitates signal coupling. An area of the first part 921 is greater than an area of the second part 922. That the second part 922 directly faces the first antenna sub-portion 91 may be understood as that a vertical projection of the second part 922 on a plane on which the first sub-portion 91 is located at least partially covers the first antenna sub-portion 91, or there is at least a partially overlapping region between a vertical projection of the second part 922 on a plane on which the first sub-portion 91 is located and the first antenna sub-portion 91. This can ensure that a spacing between the second part 922 and the first antenna sub-portion 91 meets a requirement for electromagnetic wave signal coupling.

The implementation described in FIG. 29 may also be applied to any one of the possible implementations provided in FIG. 4 to FIG. 28B.

For example, the embodiment shown in FIG. 3 is used as an example. In the implementation shown in FIG. 3, there is an air duct between the fan 52 and the air exhaust vent 13, an audio module is disposed between the first circuit board 42 and a frame of the electronic device, the audio module includes a sound cavity housing and an audio component (for example, a speaker) disposed in the sound cavity housing, and the sound cavity housing is made of an insulating material. The sound cavity housing may be a support member, and the first antenna sub-portion of the antenna is disposed on the support member. The first antenna sub-portion is of a metal patch structure. The first antenna sub-portion may be attached to the support member, or may be integrally formed with the support member. The second antenna sub-portion 92 is attached to the inner surface of the rear cover of the electronic device, the second part of the second antenna sub-portion directly faces the first antenna sub-portion, and a spacing between the second part and the first antenna sub-portion meets a requirement for electromagnetic wave signal coupling.

In conclusion, according to a first aspect, an embodiment of this application provides an electronic device. Components with different load levels and different heights are respectively arranged on two opposite sides of a rotating shaft based on respective heat dissipation requirements, to effectively reduce a thickness of the electronic device and ensure efficient performance of the electronic device. In a specific solution, in this application, a mainboard and a first heat source on the mainboard are disposed on a first middle frame, and a power management module (or a charging management module) is disposed on a second middle frame as a second heat source, to implement a good spatial layout and facilitate thinning of the electronic device.

According to a second aspect, in an embodiment of this application, an assembly structure of a fan and a middle frame is used, a through hole is disposed on the middle frame, the fan is built into the middle frame, and a reinforcing plate is used to support the fan, to implement thinning of the electronic device.

According to a third aspect, in this application, a strip-shaped hole is disposed on a flexible circuit board to segment the flexible circuit board of a large size. Specifically, a part that is on the flexible circuit board and that is located between a first fastening portion and a second fastening portion can be separated into a plurality of transmission segments with a small width, to avoid significant twisting of the flexible circuit board in a bending process, thereby prolonging a service life of the flexible circuit board.

According to a fourth aspect, in a specific implementation example of this application, a limiting structure is disposed at a position of the rotating shaft to resolve a problem of an abnormal sound in a solution in which the flexible circuit board passes through the shaft. The limiting structure can improve mechanical performance of the flexible circuit board, and can further limit a sudden form change of the flexible circuit board, thereby effectively suppressing a problem of a sudden form change in a process of opening/closing a foldable display device, and further alleviating a problem of an abnormal sound generated in the process of opening/closing the foldable display device.

According to a fifth aspect, in this application, one part of a patch structure (that is, a second antenna sub-portion) of an antenna is disposed at a position of an air exhaust channel of the fan. The other part of the patch structure (that is, a first antenna sub-portion) of the antenna is carried through a support member (for example, an insulating housing in an audio module) of a mainboard accessory, and the second part of the patch structure of the antenna is fed. Radiation performance of the antenna is implemented through coupling between the two parts of the patch structure. One part of the patch structure of the antenna is disposed on an inner surface of a rear cover of the electronic device, and directly faces the air exhaust channel, to implement that a structure of the antenna does not occupy the air exhaust channel and ensure heat dissipation efficiency.

Improvements in the foregoing several aspects together constitute an ultra-thin high-performance feature of the electronic device, and any different aspects in the foregoing several aspects may be combined with each other or independently implemented.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising:
a first middle frame, a second middle frame, a rotating shaft, and a screen, wherein the rotating shaft is connected between the first middle frame and the second middle frame, and the screen covers the first middle frame, the rotating shaft, and the second middle frame;
a first component module and a first heat dissipation assembly, disposed in an internal space, of the electronic device, in which the first middle frame is located, wherein the first heat dissipation assembly is configured to perform active heat dissipation for a first heat source in the first component module; and
a second component module, a second heat dissipation assembly, and a battery, disposed in an internal space, of the electronic device, in which the second middle frame is located, wherein the second component module is located between the battery and the rotating shaft, the second heat dissipation module is configured to perform passive heat dissipation for a second heat source in the second component module, power of the first heat source is greater than power of the second heat source, and a maximum size of the first heat source in a thickness direction of the electronic device is less than a maximum size of the second heat source in the thickness direction of the electronic device.

2. The electronic device according to claim 1, wherein the second heat dissipation assembly conducts heat from the second component module to the rotating shaft.

3. The electronic device according to claim 2, wherein a value range of a shortest distance between a heat generation center position of the second heat source and an edge of the rotating shaft is less than or equal to 5 cm.

4. The electronic device according to claim 3, wherein the edge of the rotating shaft is an edge that is adjacent to the second heat source and that is of a door panel that is of the rotating shaft and that corresponds to the second middle frame.

5. The electronic device according to any one of claims 2 to 4, wherein the second heat dissipation assembly comprises a heat dissipation plate and a thermally conductive structure, the second component module comprises a second circuit board and the second heat source, the second heat source is disposed on the second circuit board, the heat dissipation plate is located on a side that is of the second heat source and that faces away from the second circuit board, a part of the thermally conductive structure is located between the heat dissipation plate and a rear cover of the electronic device, and a part of the thermally conductive structure and the rotating shaft are disposed in a stacked manner, to transfer heat from the second heat source to the rotating shaft through the thermally conductive structure.

6. The electronic device according to claim 5, wherein the second circuit board and the second middle frame are connected through a thermally conductive medium, the screen of the electronic device is disposed on a side that is of the second middle frame and that faces away from the second circuit board, and the thermally conductive structure is located between the heat dissipation plate and the rear cover of the electronic device.

7. The electronic device according to claim 6, wherein the thermally conductive structure comprises a first thermally conductive portion and a second thermally conductive portion, the first thermally conductive portion and the second thermally conductive portion are respectively located on two opposite sides of the second heat source in the thickness direction of the electronic device, the first thermally conductive portion is located between the heat dissipation plate and the rear cover of the electronic device, and the second thermally conductive portion is located between the second middle frame and the screen; and
the first thermally conductive portion extends to overlap the rotating shaft in the thickness direction of the electronic device;
the first thermally conductive portion extends to overlap the battery in the thickness direction of the electronic device;
the second thermally conductive portion extends to overlap the rotating shaft in the thickness direction of the electronic device; or
the second thermally conductive portion extends to overlap the battery in the thickness direction of the electronic device.

8. The electronic device according to claim 5, wherein the second circuit board and the second middle frame are connected through a thermally conductive medium, and the screen of the electronic device is disposed on a side that is of the heat dissipation plate and that faces away from the second circuit board.

9. The electronic device according to claim 8, wherein a part of the thermally conductive structure is located between the heat dissipation plate and the screen, and a part of the thermally conductive structure is located between the rotating shaft and the screen.

10. The electronic device according to claim 9, wherein a part of the thermally conductive structure is located between the second middle frame and the second circuit board, and a part of the thermally conductive structure is located between the battery and the second middle frame.

11. The electronic device according to claim 10, wherein the thermally conductive structure comprises a third thermally conductive portion and a fourth thermally conductive portion, the third thermally conductive portion is located between the heat dissipation plate and the screen, and the fourth thermally conductive portion is located between the second circuit board and the second middle frame; and
the third thermally conductive portion extends to overlap the rotating shaft in the thickness direction of the electronic device; or
the fourth thermally conductive portion extends to overlap the battery in the thickness direction of the electronic device.

12. The electronic device according to any one of claims 5 to 11, wherein the electronic device further comprises a charging interface, the charging interface is located on a second side edge of the second middle frame, the second circuit board is adjacent to the second side edge, and the charging interface is electrically connected to the second circuit board.

13. The electronic device according to any one of claims 1 to 12, wherein the electronic device further comprises a stand and a stand rotating shaft, the stand and the stand rotating shaft are disposed on the second middle frame and located between the battery and the rotating shaft, the stand is connected to the stand rotating shaft and is capable of flipping, and the second component module and the stand are distributed on two sides of the stand rotating shaft.

14. The electronic device according to claim 13, wherein the electronic device further comprises a third component module, a maximum size of the third component module in the thickness direction of the electronic device is less than a maximum size of the first component module in the thickness direction of the electronic device, and the third component module and the stand are disposed in a stacked manner in the thickness direction of the electronic device.

15. The electronic device according to claim 14, wherein the third component module comprises a third circuit board and an electronic component disposed on the third circuit board, the third circuit board is connected to the second middle frame, a support structure is disposed between the electronic component and the stand, and the support structure and the second middle frame jointly enclose the third component module.

16. The electronic device according to claim 15, wherein a shielding structure is further disposed between the electronic component and the stand, the shielding structure is connected to the support structure, and the support structure, the shielding structure, and the stand are sequentially disposed in a stacked manner in the thickness direction of the electronic device.

17. The electronic device according to claim 15, wherein the electronic component on the third circuit board comprises at least one of a capacitor, a resistor, or an inductor.

18. The electronic device according to any one of claims 1 to 17, wherein the first heat source comprises at least one of a CPU module or a power supply module; or
the second heat source comprises at least one of a charging management module, a DDR module, a radio frequency chip, an audio PA, a speaker management module, a screen TCON, or a screen management module.

19. The electronic device according to claims 1 to 18, wherein the first heat dissipation assembly comprises a vapor chamber and a fan, the vapor chamber is configured to conduct heat from the first heat source to a position of the fan, the first component module comprises a first circuit board and the first heat source, the first heat source is located between the first circuit board and the vapor chamber in the thickness direction of the electronic device, there is a first spacing space between the first circuit board and the first middle frame, there is a second spacing space between the vapor chamber and the rear cover of the electronic device, and the screen of the electronic device is disposed on a side that is of the first middle frame and that faces away from the first circuit board.

20. The electronic device according to claim 19, wherein the first heat dissipation assembly comprises a cooling plate and a thermally conductive pad, and the first circuit board, the first heat source, the thermally conductive pad, the cooling plate, and the vapor chamber are sequentially disposed in a stacked manner in the thickness direction of the electronic device.

21. The electronic device according to claim 19 or 20, wherein the first middle frame is disposed between the rear cover and the screen of the electronic device in a stacked manner, the first middle frame comprises a bottom wall and a convex rib that are fastened, a through hole is disposed on the bottom wall, the convex rib is located on an outer side of the through hole, the convex rib protrudes from the bottom wall toward the rear cover in the thickness direction of the electronic device, the first heat dissipation assembly is mounted on the convex rib, and at least a part of the heat dissipation assembly is located in the through hole.

22. The electronic device according to claim 21, wherein the electronic device further comprises a reinforcing member, the reinforcing member is fastened to an end that is of the bottom wall and that is away from the convex rib, and the reinforcing member covers the through hole.

23. The electronic device according to claim 22, wherein a mounting groove is concavely disposed on a surface that is of the bottom wall and that faces away from the rear cover, and the reinforcing member is fastened in the mounting groove.

24. The electronic device according to claim 21, wherein the heat dissipation assembly comprises a fan housing and a fan rotating mechanism, the fan housing comprises an upper cover, a lower cover, and a side enclosure, the upper cover, the lower cover, and the side enclosure jointly enclose an accommodation space, the fan rotating mechanism is mounted in the accommodation space, the upper cover is provided with an air intake hole, the side enclosure is provided with an air exhaust hole, and the air intake hole and the air exhaust hole separately communicate with the accommodation space.

25. The electronic device according to claim 24, wherein there is an air intake channel between the upper cover of the fan housing and the rear cover of the electronic device, and the air intake channel communicates with the air intake hole.

26. The electronic device according to claim 24, wherein at least a part of the convex rib is disposed around the through hole, and the side enclosure of the fan housing is fastened to the convex rib.

27. The electronic device according to claim 24, wherein the upper cover comprises an upper cover flow-guiding portion, the lower cover comprises a lower cover flow-guiding portion, and the upper cover flow-guiding portion and the lower cover flow-guiding portion are disposed opposite to each other in the thickness direction of the electronic device.

28. The electronic device according to claim 27, wherein the lower cover further comprises a lower cover body, and the lower cover flow-guiding portion is connected to the lower cover body and is inclined relative to the lower cover body in a direction close to the upper cover; and/or
the upper cover further comprises an upper cover body, and the upper cover flow-guiding portion is connected to the upper cover body and is inclined relative to the upper cover body in a direction away from the lower cover.

29. The electronic device according to claim 28, wherein there is an included angle α between the lower cover flow-guiding portion and the lower cover body, and the included angle α meets 90°≤α≤170°.

30. The electronic device according to claim 28, wherein the upper cover further comprises an upper cover reinforcing portion, at least a part of the upper cover body is connected to the upper cover reinforcing portion, and the upper cover reinforcing portion protrudes relative to the upper cover body in a direction of the rear cover of the electronic device.

31. The electronic device according to claim 30, wherein the upper cover body is provided with a connecting portion, the connecting portion is connected to the upper cover reinforcing portion, the connecting portion is disposed at each of two ends of the upper cover body in a width direction of the heat dissipation assembly, and the two connecting portions are separately fastened to the convex rib.

32. The electronic device according to any one of claims 24 to 26, wherein an edge of the lower cover comprises a flat plate-shaped structure, the flat plate-shaped structure is close to the air exhaust vent, an edge region of the bottom wall of the first middle frame is adjacent to the air exhaust vent and is adjacent to the edge of the lower cover, the edge region comprises an air-guiding inclined surface, the air-guiding inclined surface is inclined and extends relative to the flat plate-shaped structure, and the air-guiding inclined surface is configured to guide air in the accommodation space of the fan housing from the air exhaust vent to an outside of the housing.

33. The electronic device according to claim 32, wherein there is an air-guiding structure at an edge that is of the upper cover of the fan housing and that is adjacent to the air exhaust vent, the air-guiding structure comprises a first part, a second part, and a third part that are sequentially connected, the second part is inclined and extends relative to the first part, a diameter of the light outlet corresponding to the third part is greater than a diameter of the air exhaust vent corresponding to the second part, and the diameter of the air exhaust vent corresponding to the second part is in a gradually expanding form.

34. The electronic device according to claim 33, wherein the first part is parallel to a surface of the flat plate-shaped structure of the lower cover, and an angle at which the second part is inclined relative to the first part is the same as an angle at which the air-guiding inclined surface is inclined relative to the flat plate-shaped structure.

35. The electronic device according to any one of claims 24 to 34, wherein the electronic device further comprises a flexible circuit board, a groove is disposed at an end that is of the lower cover and that is away from the fan rotating mechanism, and at least a part of the flexible circuit board is mounted in the groove.

36. The electronic device according to any one of claims 5 to 12, wherein the heat dissipation plate is at least one of a metal plate, a heat sink structure with a heat dissipation fin, a vapor chamber, or a combination of a metal plate and a heat pipe; or the thermally conductive structure is a graphite sheet.

37. The electronic device according to any one of claims 1 to 36, wherein the electronic device further comprises an electrical connection structure, and the electrical connection structure passes through or crosses the rotating shaft and is electrically connected between the first component module and the second component module.

38. The electronic device according to claim 37, wherein the electrical connection structure comprises at least one layer of flexible circuit board, two ends of the flexible circuit board are respectively connected to the first middle frame and the second middle frame, and at least a part of a portion that is on the flexible circuit board and that is located between the first middle frame and the second middle frame is connected to the rotating shaft; and at least one strip-shaped hole is disposed on the flexible circuit board, the strip-shaped hole extends in a second direction, at least a part of the strip-shaped hole is located between the first middle frame and the second middle frame, and the second direction is perpendicular to an axial direction of the rotating shaft.

39. The electronic device according to claim 38, wherein the flexible circuit board is separated into a plurality of transmission segments by the strip-shaped hole, the plurality of transmission segments are parts that are on the flexible circuit board and that are located between the first middle frame and the second middle frame, and at least a part of the plurality of transmission segments have different widths in the axial direction of the rotating shaft.

40. The electronic device according to claim 37, wherein the rotating shaft comprises a first door panel, a second door panel, a third door panel, and a hinge structure, and the first door panel and the third door panel are located on two opposite sides of the second door panel; the hinge structure directly faces the second door panel, and both the first door panel and the third door panel are rotatably connected to the hinge structure; the electrical connection structure comprises a flexible circuit board, and two ends of the flexible circuit board are respectively fastened to the first middle frame and the second middle frame; and the electronic device further comprises a limiting structure, the limiting structure is located on a side that is of the flexible circuit board and that faces the second door panel, and the limiting structure covers at least a part of the bendable portion.

41. The electronic device according to claim 40, wherein
the electronic device comprises a first fastening portion and a second fastening portion, the first fastening portion fastens one end of the flexible circuit board to the first middle frame, the second fastening portion fastens the other end of the flexible circuit board to the second middle frame, a part that is of the flexible circuit board and that is located between the first fastening portion and the second fastening portion has a segmentation slot, and the bendable portion located on two opposite sides of the segmentation slot comprises a first bendable portion and a second bendable portion; and
the limiting structure covers at least a part of the first bendable portion and at least a part of the second bendable portion.

42. The electronic device according to claim 41, wherein the limiting structure comprises a first limiting structure and a second limiting structure; the first limiting structure covers at least a part of the first bendable portion, and the second limiting structure covers at least a part of the second bendable portion; and the first limiting structure and the second limiting structure are integrally connected.

43. The electronic device according to claim 40, wherein the flexible circuit board comprises a first flexible substrate and a second flexible substrate that are disposed in a stacked manner, and the first flexible substrate is closer to the second door panel than the second flexible substrate; and
in the bendable portion, an elastic modulus of the first flexible substrate is less than an elastic modulus of the second flexible substrate.

44. The electronic device according to claim 43, wherein the flexible circuit board further comprises a third flexible substrate, and the second flexible substrate is located between the first flexible substrate and the third flexible substrate; and
in the bendable portion, the elastic modulus of the second flexible substrate is less than or equal to an elastic modulus of the third flexible substrate.

45. The electronic device according to any one of claims 19 to 35, wherein the electronic device further comprises a support member, a first antenna sub-portion, and a second antenna sub-portion, all of the support member, the first antenna sub-portion, and the second antenna sub-portion are disposed in the internal space, of the electronic device, in which the first middle frame is located, an inner cavity and an air duct are formed between the rear cover of the electronic device and the first middle frame, both the support member and the first circuit board are mounted in the inner cavity, the first antenna sub-portion is fastened to a side that is of the support member and that faces the rear cover and is electrically connected to the first circuit board, to feed the first antenna sub-portion, the second antenna sub-portion is fastened to a surface that is of the rear cover and that faces the middle frame, a region that is of the rear cover and that directly faces the second antenna sub-portion is a non-signal shielding region, and an antenna signal is transmitted between the first antenna sub-portion and the second antenna sub-portion through coupling.
